(19) Europäisches Patentamt
European Patent Office
Office européen des brevets

(11) EP 3 761 084 A1

(12) # EUROPEAN PATENT APPLICATION
published in accordance with Art. 153(4) EPC

(43) Date of publication:
**06.01.2021 Bulletin 2021/01**

(21) Application number: **19760588.4**

(22) Date of filing: **28.02.2019**

(51) Int Cl.:
***G02B 5/30** (2006.01)* ***B32B 7/023** (2019.01)*
***B60K 35/00** (2006.01)* ***G02F 1/1335** (2006.01)*
***G09F 9/30** (2006.01)* ***H01L 27/32** (2006.01)*
***H01L 51/50** (2006.01)* ***H05B 33/02** (2006.01)*

(86) International application number:
**PCT/JP2019/007955**

(87) International publication number:
**WO 2019/168131 (06.09.2019 Gazette 2019/36)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **28.02.2018 JP 2018035594**

(71) Applicant: **NITTO DENKO CORPORATION**
**Ibaraki-shi**
**Osaka 567-8680 (JP)**

(72) Inventors:
- **TAKEDA Tetsuro**
  **Ibaraki-shi, Osaka 567-8680 (JP)**
- **TAKADA Katsunori**
  **Ibaraki-shi, Osaka 567-8680 (JP)**
- **KIMURA Keisuke**
  **Ibaraki-shi, Osaka 567-8680 (JP)**
- **YAMASHITA Tomohiro**
  **Ibaraki-shi, Osaka 567-8680 (JP)**
- **SUGINO Yoichiro**
  **Ibaraki-shi, Osaka 567-8680 (JP)**

(74) Representative: **Gill Jennings & Every LLP**
**The Broadgate Tower**
**20 Primrose Street**
**London EC2A 2ES (GB)**

(54) **POLARIZING FILM LAMINATE FOR POWERED VEHICLE, AND OPTICAL DISPLAY PANEL IN WHICH SAID POLARIZING FILM LAMINATE IS USED**

(57) Provided is a polarizing film laminate capable of comprehensively solving the problems of polyene formation, color loss and heat-caused red discoloration. The polarizing film laminate contains an iodine concentration for the polarizing film and a water content for the polarizing film laminate which fall within a region surrounded, in an x-y orthogonal coordinate system in which the iodine concentration of the polarizing film is plotted on the x-axis, and the water content of the polarizing film laminate is plotted on the y-axis, by: a first line segment connecting a first coordinate point at which the iodine concentration is 7.0 wt% and the water content is 0.7 g/m$^2$, and a second coordinate point at which the iodine concentration is 2.2 wt% and the water content is 3.2 g/m$^2$; a second line segment connecting the second coordinate point, and a third coordinate point at which the iodine concentration is 2.2 wt% and the water content is 4.0 g/m$^2$; a third line segment connecting the third coordinate point, and a fourth coordinate point at which the iodine concentration is 3.0 wt% and the water content is 4.0 g/m$^2$; a fourth line segment connecting the fourth coordinate point, and a fifth coordinate point at which the iodine concentration is 10.0 wt% and the water content is 0.7 g/m$^2$; and a fifth line segment connecting the first coordinate point, and the fifth coordinate point.

FIG.5

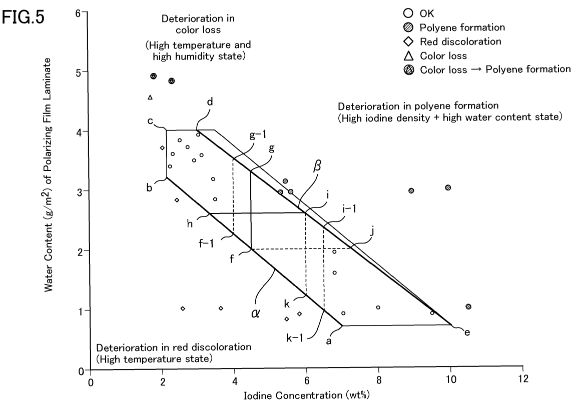


EP 3 761 084 A1

## Description

TECHNICAL FIELD

The present invention relates to a polarizing film laminate, and more specifically to a polarizing film laminate used for an optical display panel configured to be mounted to a vehicle body of a powered vehicle, and an optical display panel in which the polarizing film laminate is used.

BACKGROUND ART

In recent years, various possibilities have been developed for an optical display panel such as a liquid crystal panel or an organic EL panel, used not only for electronic devices such as smartphones and personal computers, and electric appliances such as IoT home appliances, but also for powered vehicles such as automobiles, electric trains and airplanes. For example, it is conceivable to mount an optical display panel to a front windshield, a dashboard, an exterior or any of various other vehicle body portions of an automobile, to provide variety information to drivers, and transmit variety information outside the automobile.

Unlike smart phones etc., however, powered vehicles are likely to be used in a harsh outdoor environment, and therefore performance of an optical display panel, particularly, a polarizing film laminate (polarizing plate) used in the optical display panel and further a polarizing film (polarizer) used in the polarizing film laminate, could sometimes degrade depending on, for example, a high-temperature or high-humidity usage environment, and eventually such a panel could be made unusable in the worst case.

In Patent Document 1, there is disclosed one example of each of a polarizer enhanced in terms of durability in a high temperature or high humidity environment, a polarizing plate using this polarizer, and a liquid crystal display device using this polarizing plate. Here, red light leakage (leakage of polarized light of long-wavelength light) in crossed-nicols, occurring when the liquid crystal display device is left under a high temperature condition is seen as a problem with the durability, and, in order to solve this problem, it is proposed to allow the polarizer to contain zinc, wherein the content of the zinc is adjusted to fall within a given range, in relationship with the content of iodine.

Similarly, Patent Document 2 relates to a polarizing plate used for an on-vehicle image display device, which is enhanced in terms of durability in a high temperature or high humidity environment, and here focuses on a water content of the polarizing plate, and a saturated water absorption of a protective film. Although the on-vehicle polarizing plate requires high temperature durability, the transmittance of the polarizing plate can be significantly reduced in a high temperature environment, due to polyene formation (polyenization). In order to solve this problem, in the Patent Document 2, it is proposed to use, as a transparent protective film to be laminated to a polarizer, a film having a saturated water absorption falling within a given range, and reduce the water content of the polarizing plate.

Patent Document 3 also relates to a polarizing plate which is enhanced in terms of durability in a high temperature or high humidity environment, and here focuses on a water content rate of the polarizing plate, and a water vapor permeability of a protective film. In a high temperature environment or the like, the inside of the polarizing plate comes into a high temperature and high humidity state, and thereby the amount of change in light transmittance, polarization degree, hue of an image, or the like becomes larger, resulting in poor reliability as a polarizing plate. Therefore, it is proposed to laminate a protective film having a low water vapor permeability, to a polarizer in a state in which the water content rate of the polarizer is reduced as much as possible.

CITATION LIST

[Parent Document]

Patent Document 1: JP 2003-29042A
Patent Document 2: JP 2014-102353A
Patent Document 3: JP 2002-90546A

SUMMARY OF INVENTION

[Technical Problem]

As a problem occurring in a high temperature or high humidity environment in regard to an optical display panel, particularly a polarizing film laminate used for the optical display panel, or a polarizing film used for the polarizing film

laminate, "polyene formation", "color loss" and "heat-caused red discoloration (red discoloration caused by heat)" have been known.

Generally, the "polyene formation" means a phenomenon that, as a result of being placed in a high temperature or high humidity environment, the single transmittance of the polarizing film laminate decreases, and each of the "color loss" and "heat-caused red discoloration" means a phenomenon that, as a result of being placed in a high temperature or high humidity environment in a similar manner, the crossed transmittance of the polarizing film laminate decreases as measured at each of wavelengths 410 nm and 700 nm in a state in which the polarizing film laminate is arranged in a crossed-nicols state, wherein the "color loss" is particularly known as a phenomenon that each of the transmittance on a long wavelength side with respect to about 700 nm and the transmittance on a short wavelength side with respect to about 410 nm rises, causing color loss in a black display state, and the "heat-caused red discoloration" is particularly known as a phenomenon that the transmittance on a long wavelength side with respect to about 700 rises, and thereby the polarizing film is discolored to red.

The Patent Document 1, the Patent Document 2 and the Patent Document 3 mainly focus, respectively, on the problem of "color loss", the problem of polyene formation, and the problem of "heat-caused red discoloration", solutions proposed in these Documents are considered to be effective in solving the respective problems. However, the invention described in each of the Patent Documents was not necessarily enough to comprehensively solve these problems. As a result of diligent researches based on the fact that all the "polyene formation", "color loss" and "heat-caused red discoloration" are associated with each other, through iodine and water, and further through temperature and humidity exerting an influence on the water, the present applicant has obtained knowledge that these problems can be comprehensively solved by adjusting the concentration of iodine in the polarizing film, and the water content of the polarizing film laminate. It is an object of the present invention to adjust the concentration of iodine in the polarizing film, and the water content of the polarizing film laminate, thereby comprehensively solving these three problems.

[Solution to Technical Problem]

In order to solve the above problems, according to a first aspect of the present invention, there is provided a polarizing film laminate used for an optical display panel, configured to be mounted to a vehicle body of a powered vehicle. The polarizing film laminate comprises a polarizing film comprised of a polyvinyl alcohol-based resin, and an optically transparent, polarizing film-protective film bonded to at least one of opposite surfaces of the polarizing film directly or through an additional optical film, wherein the polarizing film laminate contains an iodine concentration for the polarizing film and a water content for the polarizing film laminate which fall within a region surrounded, in an x-y orthogonal coordinate system in which the iodine concentration (wt.%) of the polarizing film is plotted on the x-axis, and the water content ($g/m^2$) of the polarizing film laminate is plotted on the y-axis, by: a first line segment connecting a first coordinate point at which the iodine concentration is 7.0 wt% and the water content is 0.7 $g/m^2$, and a second coordinate point at which the iodine concentration is 2.2 wt% and the water content is 3.2 $g/m^2$; a second line segment connecting the second coordinate point, and a third coordinate point at which the iodine concentration is 2.2 wt% and the water content is 4.0 $g/m^2$; a third line segment connecting the third coordinate point, and a fourth coordinate point at which the iodine concentration is 3.0 wt% and the water content is 4.0 $g/m^2$; a fourth line segment connecting the fourth coordinate point, and a fifth coordinate point at which the iodine concentration is 10.0 wt% and the water content is 0.7 $g/m^2$; and a fifth line segment connecting the first coordinate point, and the fifth coordinate point.

The polarizing film laminate according to the first aspect can comprehensively solve the problems of "polyene formation", "color loss" and "heat-caused red discoloration".

In the polarizing film laminate according to the first aspect, the polarizing film may have a film thickness of 4 to 20 $\mu$m.

According to a second aspect of the present invention, there is provided a polarizing film laminate used for an optical display panel configured to be mounted to a vehicle body of a powered vehicle. The polarizing film laminate comprises a polarizing film comprised of a polyvinyl alcohol-based resin, and an optically transparent, polarizing film-protective film bonded to at least one of opposite surfaces of the polarizing film directly or through an additional optical film, wherein the polarizing film laminate contains an iodine concentration for the polarizing film and a water content for the polarizing film laminate which fall within a region surrounded, in an x-y orthogonal coordinate system in which the iodine concentration (wt.%) of the polarizing film is plotted on the x-axis, and the water content ($g/m^2$) of the polarizing film laminate is plotted on the y-axis, by: a sixth line segment connecting a sixth coordinate point at which the iodine concentration is 4.5 wt% and the water content is 2.0 $g/m^2$, and a second coordinate point at which the iodine concentration is 2.2 wt% and the water content is 3.2 $g/m^2$; a second line segment connecting the second coordinate point, and a third coordinate point at which the iodine concentration is 2.2 wt% and the water content is 4.0 $g/m^2$; a third line segment connecting the third coordinate point, and a fourth coordinate point at which the iodine concentration is 3.0 wt% and the water content is 4.0 $g/m^2$; a seventh line segment connecting the fourth coordinate point, and a seventh coordinate point at which the iodine concentration is 4.5 wt% and the water content is 3.3 $g/m^2$; and an eighth line segment connecting

the sixth coordinate point, and the seventh coordinate point.

In the polarizing film laminate according to the second aspect, the sixth coordinate point may be a coordinate point at which the iodine concentration is 4.0 wt% and the water content is 2.3 g/m$^2$, and the seventh coordinate point may be a coordinate point at which the iodine concentration is 4.0 wt% and the water content is 3.5 g/m$^2$.

In the polarizing film laminate according to the second aspect, the polarizing film may have a film thickness of 11 to 20 $\mu$m.

According to a third aspect of the present invention, there is provided a polarizing film laminate used for an optical display panel configured to be mounted to a vehicle body of a powered vehicle. The polarizing film laminate comprises a polarizing film comprised of a polyvinyl alcohol-based resin, and an optically transparent, polarizing film-protective film bonded to at least one of opposite surfaces of the polarizing film directly or through an additional optical film, wherein the polarizing film laminate contains an iodine concentration for the polarizing film and a water content for the polarizing film laminate which fall within a region surrounded, in an x-y orthogonal coordinate system in which the iodine concentration (wt.%) of the polarizing film is plotted on the x-axis, and the water content (g/m$^2$) of the polarizing film laminate is plotted on the y-axis, by:

an eleventh line segment connecting a first coordinate point at which the iodine concentration is 7.0 wt% and the water content is 0.7 g/m$^2$, and an eighth coordinate point at which the iodine concentration is 3.0 wt% and the water content is 2.6 g/m$^2$; a tenth line segment connecting the eighth coordinate point, and a ninth coordinate point at which the iodine concentration is 6.0 wt% and the water content is 2.6 g/m$^2$; a twelfth segment connecting the ninth coordinate point, and a fifth coordinate point at which the iodine concentration is 10.0 wt% and the water content is 0.7 g/m$^2$; and a fifth line segment connecting the first coordinate point, and the fifth coordinate point.

The polarizing film laminate according to the third aspect can comprehensively solve the problems of the "polyene formation", the "color loss" and the "heat-caused red discoloration".

In the polarizing film laminate according to the third aspect, the eighth coordinate point may be a sixth coordinate point at which the iodine concentration is 4.5 wt% and the water content is 2.0 g/m$^2$, and the ninth coordinate point may be a tenth coordinate point at which the iodine concentration is 7.2 wt% and the water content is 2.0 g/m$^2$, and

In the polarizing film laminate according to the third aspect, the polarizing film may have a film thickness of 4 to 11 $\mu$m.

In the polarizing film laminate according to any one of the first to third aspects, the polarizing film preferably contains zinc.

In the polarizing film laminate according to any one of the first to third aspects, with regard to a sample comprised of the polarizing film laminate and two glass plates each laminated to a respective one of opposite surfaces of the polarizing film laminate through a pressure-sensitive adhesive layer, a single transmittance of the sample as measured after heating at 95°C for 500 hours is preferably equal or greater than that of the sample before the heating.

According to this feature, the problem of the polyene formation can be effectively solved.

In the polarizing film laminate according to any one of the first to third aspects, with regard to a sample comprised of the polarizing film laminate and two glass plates each laminated to a respective one of opposite surfaces of the polarizing film laminate through a pressure-sensitive adhesive layer, an amount of change in cross transmittance of the sample at a wavelength of 410 nm due to heating at 95°C for 500 hours is preferably less than 1%, and an amount of change in cross transmittance of the sample at a wavelength of 700 nm due to the heating is preferably less than 5%.

According to this feature, the problem of the color loss can be effectively solved.

In the polarizing film laminate according to any one of the first to third aspects, with regard to a sample comprised of the polarizing film laminate recited and two glass plates each laminated to a respective one of opposite surfaces of the polarizing film laminate through a pressure-sensitive adhesive layer, an amount of change in cross transmittance of the sample at a wavelength of 410 nm due to heating at 95°C for 500 hours is preferably 1% or more, and an amount of change in cross transmittance of the sample at a wavelength of 700 nm due to the heating is preferably less than 5%.

According to this feature, the problem of the heat-caused red discoloration can be effectively solved.

In the polarizing film laminate according to any one of the first to third aspects, an antireflective layer may be provided on a viewing-side surface of the polarizing film through a substrate, and wherein an antireflective film comprised of the substrate and the antireflective layer may have a water vapor permeability of equal to or more than 15 g/m$^2$·24 h.

Preferably, the polarizing film laminate according to any one of the first to third aspects comprises: a liquid crystal cell having a liquid crystal layer containing liquid crystal molecules oriented in one direction in a plane thereof in an electric field non-applied state; a first polarizing film disposed on one of opposite sides of the liquid crystal cell; a second polarizing film disposed on the other side of the liquid crystal cell, such that an absorption axis thereof becomes orthogonal to an absorption axis of the first polarizing film, wherein a first retardation layer and a second retardation layer are arranged between the first polarizing film and the liquid crystal cell, in this order from a side of the first polarizing film, wherein the first retardation layer is configured to satisfy a relationship of nxl > ny1 > nz1, where: nx1 represents a refractive index in an in-plane slow axis (x-axis) direction; ny1 represents a refractive index in an in-plane fast axis direction; and nz1 represents a refractive index in a thickness (z) direction, and the second retardation layer is configured

to satisfy a relationship of nz2 > nx2 ≧ ny2, where: nx2 represents a refractive index in the in-plane slow axis (x-axis) direction; ny2 represents a refractive index in the in-plane fast axis direction; and nz2 represents a refractive index in the thickness (z) direction.

Preferably, the polarizing film laminate according to any one of the first to third aspects comprises: a liquid crystal cell having a liquid crystal layer containing liquid crystal molecules oriented in one direction in a plane thereof in an electric field non-applied state; a first polarizing film disposed on one of opposite sides of the liquid crystal cell; a second polarizing film disposed on the other side of the liquid crystal cell, such that an absorption axis thereof becomes orthogonal to an absorption axis of the first polarizing film, wherein a first retardation layer and a second retardation layer are arranged between the first polarizing film and the liquid crystal cell, in this order from a side of the first polarizing film, wherein the first retardation layer is configured to satisfy a relationship of nz1 > nx1 = ny1, where: nx1 represents a refractive index in an in-plane slow axis (x-axis) direction; ny1 represents a refractive index in an in-plane fast axis direction; and nz1 represents a refractive index in a thickness (z) direction, and the second retardation layer is configured to satisfy a relationship of nx2 > ny2 = ny2, where: nx2 represents a refractive index in the in-plane slow axis (x-axis) direction; ny2 represents a refractive index in the in-plane fast axis direction; and nz2 represents a refractive index in the thickness (z) direction.

Preferably, the polarizing film laminate according to any one of the first to third aspects comprises: a liquid crystal cell having a liquid crystal layer containing liquid crystal molecules oriented in one direction in a plane thereof in an electric field non-applied state; and a polarizing film disposed on one of opposite sides of the liquid crystal cell, wherein a retardation layer is disposed between the polarizing film and the liquid crystal cell, wherein the retardation layer is configured to satisfy a relationship of nx > nz > ny, where: nx represents a refractive index in an in-plane slow axis (x-axis) direction; ny represents a refractive index in an in-plane fast axis direction; and nz represents a refractive index in a thickness (z) direction.

In order to solve the above problems, according to a fourth aspect of the present invention, there is provided an optical display panel configured to be mounted to a vehicle body of a powered vehicle. The optical display panel comprises: an optical display cell; the polarizing film laminate according to any one of the first to third aspects, wherein the polarizing film laminate is bonded to one of opposite surfaces of the optical display cell directly or through an additional optical film; and an optically transparent cover plate disposed along the polarizing film laminate, on a side opposite to the optical display cell, and wherein any adjacent two of the optical display cell, the polarizing film laminate and the transparent cover plate are adhesively attach to each other by a transparent adhesive layer filled therebetween in a gap-free manner.

In the optical display panel according to the fourth aspect, the transparent cover plate may have a function of a capacitive touch sensor.

In the above optical display panel, an ITO layer serving as a component of the capacitive touch sensor may be provided between the transparent cover plate and the polarizing film laminate.

[Effect of Invention]

The present invention makes it possible to comprehensively solve the problems of the "polyene formation", the "color loss" and the "heat-caused red discoloration".

BRIEF DESCRIPTION OF DRAWINGS

FIG. 1 is a schematic diagram showing a layer configuration of an optical display panel.

FIG. 2 is an explanatory diagram of one example of a manufacturing method for a polarizing film.

FIG. 3 is a graph showing a calibration curve for determining an iodine concentration of a polarizing film.

FIG. 4 is a diagram showing a structure for a reliability test.

FIG. 5 is a graph in which results of Inventive and Comparative Examples are plotted.

FIG. 6 is a schematic diagram showing one example of a layer configuration in which an antireflective function is added to a polarizing film laminate.

FIG. 7 is a schematic diagram showing one example of a layer configuration of an optical display panel obtained by adding two retardation layers for two-sheet compensation.

FIG. 8 is a schematic diagram showing one example of a layer configuration of an optical display panel obtained by adding a retardation layer for one-sheet compensation.

DESCRIPTION OF EMBODIMENTS

With reference to the accompanying drawings, the present invention will now be described based on one preferred embodiment thereof. It is to be understood that, although only the preferred embodiment will be described for the purpose of illustration, the embodiment is not intended to limit the present invention.

The present invention is intended for an optical display panel, particularly an optical display panel configured to be mounted to a vehicle body of a powered vehicle such as an automobile, an electric train or an airplane, and a polarizing film laminate used for the optical display panel. Here, the term "mounted to a vehicle body" is not necessarily limited to a case where the optical display panel or the polarizing film laminate is fixed to the vehicle body, but also includes a case where, when the optical display panel or the polarizing film laminate is used in, e.g., a smartphone or the like, it is freely brought in or carried in the powered vehicle. Further, the term "mounted to a vehicle body" includes any situation where the optical display panel or the polarizing film laminate is used together with the powered vehicle, and is likely to be exposed to a high temperature or high humidity environment.

1. Optical Display Panel

FIG. 1 is a schematic diagram showing a layer configuration of an optical display panel 1. The optical display panel 1 comprises, at least, an optical display cell 10, a polarizing film laminate 12 laminated on one (viewing-side one) 10a of opposite surfaces of the optical display cell 10, and an optically transparent cover plate 14 disposed along the polarizing film laminate 12, on the side opposite to the optical display cell 10, i.e., on a viewing side. An additional polarizing film laminate 17 is disposed on the side of the other surface 10b of the optical display cell 10 through a transparent adhesive 16. Adjacent two of the optical display cell 10, the polarizing film laminate 12 and the cover plate 14 are adhesively attached to each other by a respective one of two transparent adhesives 11, 13 each filled therebetween in a gap-free manner. Here, as used in this specification, the term "adhesive" includes pressure-sensitive adhesive, unless otherwise specified. The optical display cell 10 may be adhesively attached to the polarizing film laminate 12 directly through the transparent adhesive 11. Alternatively, it may be adhesively attached to the polarizing film laminate 12 through an additional optical film such as a retardation film, or a viewing-angle compensation film (not illustrated), where needed.

1-1. Optical Display Cell

Examples of the optical display cell 10 include a liquid crystal cell and an organic EL cell.

As the organic EL cell, e.g., a light emitter (organic electroluminescence light emitter) is preferably used which is formed by laminating a transparent electrode, an organic light-emitting layer and a metal electrode on a transparent substrate, in this order. The organic light-emitting layer is a laminate of various organic thin films, and it is possible to employ any of various layer configurations, such as: a laminate of a hole injection layer comprised of a triphenylamine derivative or the like and a light-emitting layer comprised of a fluorescent organic solid such as anthracene; a laminate of the light-emitting layer, and an electron injection layer comprised of a perylene derivative or the like; and a laminate of the hole injection layer, the light-emitting layer, and the electron injection layer.

As the liquid crystal cell, it is allowable to use any one of a reflective liquid crystal cell using external light, a transmissive liquid crystal cell using light from a light source such as a backlight 18, and a transflective liquid crystal cell using both external light and light from a light source. When the liquid crystal cell is configured to use light from a light source, the polarizing film laminate 17 is additionally disposed on the side opposite to the viewing side of the optical display cell (liquid crystal cell) 10, and a light source 18 such as a backlight is further disposed. The light source-side polarizing film laminate 17 and the liquid crystal cell 10 are adhesively attached to each other through a layer of the appropriate transparent adhesive 17. As a driving mode of the liquid crystal cell, it is possible to use any of various types such as VA mode, IPS mode, TN mode, STN mode, or bend alignment ($\pi$) mode.

1-2. Cover Plate

Examples of the cover plate 14 include a transparent plate (window layer) and a touch panel. As the transparent plate, a transparent plate having appropriate mechanical strength and thickness is used. As such a transparent plate, for example, a transparent resin plate such as an acrylic resin or a polycarbonate-based resin, or a glass plate, is used. The surface of the cover plate 14 may be subjected to a low-reflection treatment, e.g., by using a low-reflection film (not illustrated). As the touch panel, any of various types of touch panels such as resistive film type, capacitance type, optical type and ultrasonic type, a glass or transparent resin plate having a touch sensor function or the like is used.

When a capacitance touch panel is used as the cover plate 14, it is preferable to provide a front transparent plate comprised of glass or a transparent resin plate, on the viewing side with respect to the touch panel. In this case,

an ITO layer (not illustrated) serving as a component of the capacitance touch panel is provided in the transparent adhesive 13 bonding between the cover plate 14 and the polarizing film laminate 12.

1-3. Transparent Adhesives

As the transparent adhesives 11, 13, 16, it is possible to appropriately use any of various adhesives such as an adhesive as disclosed in JP 6071459B. For example, a (meth)acrylic adhesive may be used, or a curable adhesive containing no (meth)acrylic acid may be used. As an example of the latter, for example, an isoprene-based UV curable adhesive is preferably used. The isoprene-based UV curable adhesive may contain isoprene as a monomer component, or an isoprene derivative. The adhesive may contain a monomer component other than the isoprene-based monomer. Examples of the monomer component may include a (meth)acrylic acid derivative such as (meth)acrylic acid ester. Here, reducing the content of an acid component in each of the transparent adhesives 11, 13, 16 is effective in suppressing a decrease in transmittance due to formation of polyene from polyvinyl alcohol.

2. Polarizing Film Laminate

The polarizing film laminate 12 comprises, at least, a polarizing film 120, and a polarizing film-protective film 121 bonded to at least one (e.g., a viewing-side one) of opposite surfaces of the polarizing film 12. As in this embodiment, two polarizing film-protective films 121, 122 may be bonded, respectively, to the opposite surfaces of the polarizing film 120, i.e., a viewing-side one of the opposite surfaces of the polarizing film 120 and the other surface on the side opposite to the viewing-side surface, through an appropriate adhesive (not illustrated).. Although not particularly illustrated, an additional optical film may be provided between the polarizing film 120 and one or each of the polarizing film-protective films 121, 122.

The present invention focuses on the concentration (wt. %) of iodine in the polarizing plate 120, and a water content ($g/m^2$) of the polarizing film laminate 12, in order to comprehensively solve problems occurring in a high temperature and high humidity environment, particularly the problem of the "polyene formation", the "color loss" and the "heat-caused red discoloration". A value of each of these parameters can be adjusted during manufacturing of a respective one of the polarizing film and the polarizing film laminate.

2-1. Polarizing Film

The polarizing film 120 is comprised of an iodine-containing polyvinyl alcohol (PVA)-based resin film. As a material for the PVA-based film used as the polarizing film, PVA of a derivative thereof is used. Examples of the derivative of PVA include polyvinyl formal and polyvinyl acetal, as well as polyvinyl alcohol modified with: olefin such as ethylene or propylene; an unsaturated carboxylic acid such as acrylic acid, methacrylic acid or crotonic acid; or an alkyl ester thereof; and an acryl amide. As the PVA, a certain type of PVA having a polymerization degree of about 1000 to 10000, and a saponification degree of about 80 to 100 mol% is generally used. A PVA-based film made of this material tends to be more likely to contain water.

The PVA-based film may contain an additive such as a plasticizer. Examples of the plasticizer include polyols and condensates thereof, such as glycerin, diglycerin, triglycerin, ethylene glycol, propylene glycol, and polyethylene glycol. The amount of the plasticizer to be used is preferably, but not limited to, 20 weight% or less, with respect to the total amount of the PVA-based film.

2-1-1. Manufacturing of Polarizing Film

In manufacturing of a polarizing film having a film thickness of 6 μm or more, the PVA-based film is subjected to dying in which it is dyed with iodine, and stretching in which it is stretched in at least one direction. Generally, a method is employed which is configured to subject the PVA-based film to a series of processes comprising swelling, dyeing, cross-linking, stretching, water washing and drying.

The swelling process is performed, e.g., by immersing the PVA-based film in a swelling bath (water bath). Through this process, it is possible to wash off contamination or an antiblocking agent on the surface of the PVA-based film, and cause the PVA-based film to be swollen, thereby preventing non-uniformity such as dyeing unevenness. Glycerin, potassium iodide or the like may be appropriately added to the swelling bath. The temperature of the swelling bath is, e.g., about 20 to 60°C, and a time period of immersion in the swelling bath is, e.g., about 0.1 to 10 minutes.

The dyeing process is performed, e.g., by immersing the PVA-based film in an iodine solution. Generally, the iodine solution is an iodine aqueous solution which contains iodine, and potassium iodide as dissolution aid. The concentration of iodine is, e.g., about 0.01 to 1 weight%, preferably 0.02 to 0.5 weight%. The concentration of potassium iodide is, e.g., about 0.01 to 10 weight%, preferably 0.02 to 8 weight%.

In the dyeing process, the temperature of the iodine aqueous solution is, e.g., about 20 to 50°C, preferably 25 to 40°C. The immersion time period is, e.g., in the range of about 10 to 300 seconds, preferably 20 to 240 seconds. To prepare for the iodine-dyeing process, conditions such as the concentration of the iodine solution, the temperature and time period of immersion of the PVA-based film into the iodine aqueous solution, and others are adjusted such that each of the contents of iodine and potassium in the PVA-based film falls within a respective one of the above ranges.

The cross-linking process is performed, i.e., by immersing the iodine-dyed PVA-based film in a process bath containing a cross-linking agent. As the cross-linking agent, any appropriate cross-linking agent may be employed. Specific examples of the cross-linking agent include boron compounds such as boric acid and borax, glyoxal, and glutaraldehyde. These may be used independently, or in combination. As a solvent used for a solution of a cross-linking bath, water is commonly used, wherein an organic solvent compatible with water may be added thereto in a proper amount. The cross-linking agent is used, e.g., in an amount of 1 to 10 weight parts, with respect to 100 weight parts of the solvent. The solution of the cross-linking bath preferably contains an aid such as an iodide. The concentration of the aid is preferably 0.05 to 15 weight%, more preferably 0.5 to 8 weight%. The temperature of the cross-linking bath is, e.g., about 20 to 70°C, preferably 40 to 60°C. A time period of immersion in the cross-linking bath is, e.g., about 1 second to about 15 minutes, preferably 5 seconds to 10 minutes.

The stretching process is a process in which the PVA-based film is stretched in at least one direction. Generally, the PVA-based film is uniaxially stretched in a conveyance direction (longitudinal direction) thereof. A stretching method is not particularly limited, and any of a wet stretching method and a dry stretching method may be employed. In a case where the wet stretching method is employed, the PVA-based film is stretched in a process bath at a given ratio. As a solution of a stretching bath, it is preferable to use a solution obtained by adding a compound or the like necessary for various processes to a solvent such as water or an organic solvent (e.g., ethanol). Examples of the dry stretching method include an inter-roll stretching method, a heated roll stretching method, and a compression stretching method. In the manufacturing of the polarizing film, the stretching process may be performed in any stage. Specifically, it may be performed simultaneously with the swelling, the dyeing or the cross-linking, or may be performed before or after any of these processes. Further, the stretching may be performed in a multi-stage manner. A cumulative stretch ratio of the PVA-based film is, e.g., 5 or more, preferably about 5 to 7.

The PVA-based film subjected to the above processes (stretched film) is subjected to the water washing process and the drying process, according to the common procedure.

The water washing process is performed, e.g., by immersing the PVA-based film in a water washing bath. The water washing bath may be pure water, or may be an aqueous solution of iodide (e.g., potassium iodide or sodium iodide). The concentration of an iodide aqueous solution is preferably 0.1 to 10 weight %. An aid such as zinc sulfate or zinc chloride may be added to the iodide aqueous solution.

The temperature of the water washing bath is, e.g., 5 to 50°C, preferably 10 to 45°C, more preferably 15 to 40°C. A time period of the immersion is, e.g., about 10 to 300 seconds, preferably 20 to 240 seconds. The water washing process may be implemented only once, or may be implemented plural times where needed. In a case where the water washing process is implemented plural times, the type and concentration of the additive contained in the water washing bath used for each process may be appropriately adjusted.

The process of drying the PVA-based film is performed by any appropriate method (e.g., natural drying, blow drying, or drying by heating).

2-1-2. Manufacturing of Polarizing Film

A polarizing film having a film thickness of less than 6 μm can be manufactured by a manufacturing method disclosed in, e.g., JP 4751481B. This manufacturing method comprises: a laminate production process of forming a PVA-based resin film on a thermoplastic substrate; a stretching process of stretching the PVA-based resin film integrally with the thermoplastic substrate; and a dyeing process of adsorbing a dichroic material to the PVA resin layer. Further, the PVA-based resin layer may be subjected to an insolubilization process, a cross-linking process, a drying process, a washing process, etc., where needed. The stretching process may be implemented before or after the dyeing process, and, in the stretching process, it is possible to employ either of in-air stretching, and in-water stretching such as stretching in a boric acid aqueous solution. Further, the stretching may be a single-stage stretching or may be two or more-stage or multi-stage stretching.

With reference to FIG. 2, one example of the polarizing film manufacturing method will be described. Here, the polarizing film is produced by stretching a PVA-based resin layer formed on a resin substrate, together with the resin substrate.

[Laminate Production Process (A)]

First of all, a 200 μm-thick non-crystallizable ester-based thermoplastic resin substrate having a glass transition

temperature of 75°C, e.g., isophthalic acid-copolymerized polyethylene terephthalate copolymerized with 6 mol% of isophthalic acid (hereinafter referred to as "non-crystallizable PET") 6, and a PVA aqueous solution having a PVA concentration of 4 to 5 weight%, obtained by dissolving, in water, a PVA powder having a polymerization degree of 1000 or more and a saponification degree of 99% or more, are prepared. Then, in a laminate production apparatus 20 equipped with a coating device 21, a drying device 22 and a surface modifying unit 23, the PVA aqueous solution is applied to the non-crystallizable PET substrate 6, and dried at a temperature of 50 to 60°C to form, on the PET substrate 1, a 7 μm-thick PVA layer 2 having a glass transition temperature of 80°C. In this way, a laminate 7 comprising the 7 μm-thick PVA layer is produced. In this process, the surface of the non-crystallizable PET substrate 6 can be subjected to corona treatment by the surface modifying unit 23, thereby improving adhesion between the non-crystallizable PET substrate 6 and the PVA layer 2 formed on the non-crystallizable PET substrate 6.

Subsequently, the laminate 7 comprising the PVA layer will be produced as a 3 μm-thick polarizing film through the following processes including a 2-stage stretching process consisting of preliminary in-air stretching and in-boric-acid-solution stretching.

[Preliminary In-Air Stretching Process (B)]

In a first-stage preliminary in-air stretching process (B), the laminate 7 comprising the 7 μm-thick PVA layer 2 is stretched integrally with the PET substrate 6 to form a "stretched laminate 8" comprising a 5 μm-thick PVA layer 2. Specifically, in a preliminary in-air stretching apparatus 30 having an oven 33 in which a stretching device 31 is installed, the laminate 7 comprising the 7 μm-thick PVA layer 2 is subjected to free-end uniaxial stretching through the stretching device 31 of the oven 33 having a stretching temperature environment set at 130°C, so as to attain a stretch ratio of 1.8, thereby forming a stretched laminate 8. At this stage, a roll 8' of the stretched laminate 8 can be produced by using a take-up unit 32 installed in side-by-side relation to the oven 33.

[Dyeing Process (C)]

Subsequently, in the dyeing process (C), a dyed laminate 9 is formed in which iodine as a dichroic material is adsorbed to the 5 μm-thick PVA layer 2 having oriented PVA molecules. Specifically, in a dyeing apparatus 40 equipped with a dyeing bath 42 of a dyeing solution 41 containing iodine and potassium iodide, the stretched laminate 8 unrolled from a feeding unit 43 installed in side-by-side relation to the dyeing apparatus 40 and loaded with the roll 8' is immersed in the dyeing solution 41 at a solution temperature of 30°C, for an arbitrary time, so as to allow a PVA layer constituting a finally-formed polarizing film to have a single transmittance of 40 to 44%, thereby forming a dyed laminate 9 in which iodine is absorbed to the molecularly-oriented PVA layer 2 of the stretched laminate 8.

In this process, in order to prevent dissolution of the PVA layer 2 comprised in the stretched laminate 8, the dyeing solution 41 is prepared such that the concentration of iodine is set to 0.30 weight%, using water as a solvent. Further, in the dyeing solution 41, the concentration of potassium iodide for allowing iodine to be dissolved in water is set to 2.1 weight%. The concentration ratio of iodine to potassium iodide is 1 : 7. More specifically, the stretched laminate 8 is immersed in the dyeing solution 41 having an iodine concentration of 0.30 weight% and a potassium iodide concentration of 2.1 weight%, for 60 seconds, thereby forming a dyed laminate 9 in which iodine is adsorbed to the 5 μm-thick PVA layer 2 having oriented PVA molecules.

[In-Boric-Acid-Solution Stretching Process (D)]

In a second-stage in-boric-acid-solution stretching process (D), the dyed laminate 9 comprising the PVA layer 2 having molecularly-oriented iodine is further stretched to form an optical film laminate 60 which comprises the PVA layer having molecularly-oriented iodine and making up a 3 μm-thick polarizing film 3. Specifically, in an in-boric-acid-solution stretching apparatus 50 equipped with a stretching device 53 and a boric acid bath 52 of a boric acid aqueous solution 51 containing boric acid and potassium iodide, the dyed laminate 9 continuously fed from the dyeing apparatus 40 is immersed in the boric acid aqueous solution 51 having a stretching temperature environment set at a solution temperature of 65°C, and then subjected to free-end uniaxial stretching through the stretching device 53 installed in the in-boric-acid-solution stretching apparatus 50, so as to attain a stretch ratio of 3.3, thereby forming an optical film laminate 60 comprising a 3 μm-thick PVA layer.

[Washing Process (G)]

Subsequently, the optical film laminate 60 comprising the polarizing film is preferably fed directly to a washing process (G). The washing process (G) is intended to wash off unnecessary residuals adhered on the surface of the polarizing film. Alternatively, the washing process (G) may be omitted, and the pulled-out optical film laminate 60 comprising the polarizing film may be directly fed to a drying process (H).

[Drying Process (H)]

The washed optical film laminate 60 is fed to the drying process (H) and dried therein. Then, the dried optical film laminate 60 is wound as a continuous web of the optical film laminate 60 by a take-up unit 91 installed in side-by-side relation to the drying apparatus 90, to form a roll of the optical film laminate 60 comprising the polarizing film. As the drying process (H), it is possible to employ any appropriate method such as natural drying, blow drying and drying by heating. For example, the drying may be performed by warm air at 60°C., for 240 seconds in an oven type drying apparatus 90.

2-1-3. Others

The polarizing film preferably contains zinc. By allowing the polarizing plate to contain zinc, a decrease in transmittance and a degradation in hue of the polarizing film laminate after a heating test tend to be suppressed. In the case where the polarizing film contains zinc, the content of zinc in the polarizing film is preferably 0.002 to 2 weight%, more preferably 0.01 to 1 weight%.

Further, the polarizing film preferably contains sulfate ions. By allowing the polarizing plate to contain sulfate ions, the decrease in transmittance of the polarizing film laminate after the heating test tends to be suppressed. In the case where the polarizing film contains sulfate ions, the content of sulfate ions in the polarizing film is preferably 0.02 to 0.45 weight%, more preferably 0.05 to 0.35 weight%, further preferably 0.1 to 0.25 weight%. Here, the content of sulfate ions in the polarizing film is calculated from the content of sulfur atoms.

In the polarizing film manufacturing process, it is preferable to perform a zinc impregnation process so as to allow zinc to be contained in the polarizing film. Further, in the polarizing film manufacturing process, it is preferable to perform sulfate ion process so as to allow sulfate ions to be contained in the polarizing film.

The zinc impregnation process is performed, e.g., by immersing the PVA-based film in a zinc salt solution. As the zinc salt, an aqueous solution of an inorganic salt compound such as: zinc halide including zinc chloride and zinc iodide; zinc sulfate; or zinc acetate, is preferable. Further, any of various zinc complex compounds may be used in the zinc impregnation process. As the zinc salt solution, an aqueous solution containing potassium ions and iodine ions derived from potassium iodide or the like is preferably used, because it can facilitate impregnation of zinc ions. The concentration of potassium iodide in the zinc salt solution is preferably 0.5 to 10 weight%, and more preferably 1 to 8 weight%.

The sulfate ion process is performed, e.g., by immersing the PVA-based film in an aqueous solution containing a metal sulfate. As the metal sulfate, a certain type of metal sulfate is preferable which is more likely to be separated into sulfate ions and metal ions in a process liquid and then introduced into the PVA-based film in the form of ions. Examples of the type of metal forming the metal sulfate include: alkali metals such as sodium and potassium; alkaline earth metals such as magnesium and calcium; and transition metals such as cobalt, nickel, zinc, chromium, aluminum, copper, manganese, and iron.

In the polarizing film manufacturing, each of the zinc impregnation process and the sulfate ion process may be performed at any stage. That is, each of the zinc impregnation process and the sulfate ion process may be performed before or after the dyeing process. The zinc impregnation process and the sulfate ion process may be concurrently performed.

Preferably, the zinc impregnation process and the sulfate ion process are concurrently performed by using zinc sulfate as the zinc salt and the metal sulfate, and immersing the PVA-based film in a process bath containing zinc sulfate. Further, the zinc impregnation process and/or the sulfate ion process can be performed concurrently with the dying process by allowing the zinc salt and/or the metal sulfate to coexist in the dying solution. Each of the zinc impregnation process and the sulfate ion process may be performed concurrently with the stretching.

2-2. Polarizing Film-Protective Film

Examples of a material constituting each of the polarizing film-protective films 121, 122 include a thermoplastic resin which is excellent in terms of transparency, mechanical strength and thermal stability. Specific examples of this thermoplastic resin include: a cellulose-based resin such as triacetylcellulose; a polyester-based resin, polyether sulfone-based resin, a polysulfone-based resin, a polycarbonate-based resin, a polyamide-based resin, a polyimide-based resin, a polyolefin-based resin, a (meth)acrylic resin, a cyclic polyolefin-based resin (norbornene resin), a polyarylate-based resin, a polystyrene-based resin, a PVA-based resin, and mixtures thereof.

The polarizing film-protective film may additionally have a function of a retardation film.

The thickness of the polarizing film-protective film is appropriately adjusted to adjust the water content of the

polarizing film laminate. In view of thin-layer properties, and operability such as strength and handleability, the thickness is preferably about 1 to 500 μm, more preferably 2 to 300 μm, further preferably 5 to 200 μm.

The polarizing film-protective film may contain one or more arbitrary types of additives. Examples of the additives include an ultraviolet absorber, an antioxidant, a lubricant, a plasticizer, a release agent, an anti-discoloration agent, a flame retardant, a nucleating agent, an antistatic agent, a pigment, and a colorant.

2-3. Additional Optical Film(s)

Although the polarizing film and each of the polarizing film-protective films may be directly bonded together, they may be laminated together with an additional optical film. Examples of the additional (or other) optical film may include, but are not particularly limited to, a retardation film and a viewing-angle compensation film. The retardation film as the additional optical film may additionally have a function of a protective film.

The polarizing film-protective film may additionally have a function of a retardation film, as mentioned above. In this case, the above retardation film as the additional optical film may be omitted. On the other hand, even in the case where the polarizing film-protective film may additionally have a function of a retardation film, the above retardation film as the additional optical film may be provided. In this case, the polarizing film laminate substantially comprises two or three or more retardation films.

2-4. Adhesive

For example, a radical polymerization-curable adhesive, a cationic polymerization-curable adhesive, or an aqueous adhesive can be used for bonding between the polarizing film 120 and each of the polarizing film-protective films 121, 122 or bonding between the second film such as the retardation film and each of the films 120, 121, 122.

(Radical Polymerization-Curable Adhesive)

The radical polymerization-curable adhesive comprises a radically polymerizable compound as a curable compound. The radically polymerizable compound may be a compound which is curable by active energy rays, or may be a compound which is curable by heat. Examples of the active energy rays include an electron beam, UV light, and visible light.

Examples of the radically polymerizable compound include a compound containing a radically polymerizable functional group having a carbon-carbon double bond such as a (meth)acryloyl group or a vinyl group. As the radically polymerizable compound, a polyfunctional radically polymerizable compound is preferably used. The radically polymerizable compounds may be used independently or in the form of a combination of two or more of them. Further, the polyfunctional radically polymerizable compound and a monofunctional radically polymerizable compound may be used in combination.

As the polymerizable compound, a compound having a high log P value (octanol/water partition coefficient) is preferably used, and it is also preferable to select a compound having a high log P value, as the radically polymerizable compound. Here, the log P value is an index representing a lipophilic property of a material, and means a logarithmic value of the octanol/water partition coefficient. A higher log P value means stronger lipophilic property, i.e., lower water-absorbing property. The log P value can be measured (shake flask method described in JIS-Z-7260), and can be computed by calculation (ChemDraw Ultra manufactured by CambridgeSoft) based on structures of compounds each of which is a component (curable component or the like) of the curable adhesive.

The log P value of the radically polymerizable compound is preferably 2 or more, more preferably 3 or more, particularly preferably 4 or more. As long as it falls within such a range, it is possible to prevent degradation of the polarizer due to water, and obtain a polarizing plate which is excellent in terms of durability under high temperature and high humidity.

Examples of the polyfunctional radically polymerizable compound include: esterified products of a (meth)acrylate and a polyhydric alcohol, such as tripropylene glycol di(meth)acrylate, tetraethylene glycol di(meth)acrylate, 1,6-hexanediol di(meth)acrylate, 1,9-nonanediol di(meth)acrylate, 1,10-decanediol diacrylate, 2-ethyl-2-butylpropanediol di(meth)acrylate, bisphenol A di(meth)acrylate, bisphenol A-ethylene oxide adduct di(meth)acrylate, bisphenol A-propylene oxide adduct di(meth)acrylate, bisphenol A diglycidyl ether di(meth)acrylate, neopentyl glycol di(meth)acrylate, tricyclodecanedimethanol di(meth)acrylate, cyclic trimethylolpropane formal (meth)acrylate, dioxane glycol di(meth)acrylate, trimethylolpropane tri(meth)acrylate, pentaerythritol tri(meth)acrylate, pentaerythritol tetra(meth)acrylate, dipentaerythritol penta(meth)acrylate, dipentaerythritol hexa(meth)acrylate, and EO-modified diglycerin tetra(meth)acrylate; 9,9-bis[4-(2-(meth)acryloyloxyethoxy) phenyl]fluorene; epoxy (meth)acrylate; urethane(meth)acrylate; and polyester(meth)acrylate.

Among the polyfunctional radically polymerizable compounds, a polyfunctional radically polymerizable compound having a high log P value is preferable. Examples of this compound include: an alicyclic(meth)acrylate such as tricyclodecanedimethanol di(meth)acrylate (log P = 3.05) or isobornyl(meth)acrylate (log P = 3.27); a long-chain aliphatic(meth)acrylate such as 1,9-nonanediol di(meth)acrylate (log P = 3.68) or 1,10-decanediol diacrylate (log P = 4.10); a multibranched (meth)acrylate such as neopentyl glycol hydroxypivalate-(meth)acrylic acid adduct (log P = 3.35) or 2-ethyl-2-butylpropanediol di(meth)acrylate (log P = 3.92); and an aromatic ring-containing (meth)acrylate such as bisphenol A di(meth)acrylate (log P = 5.46), bisphenol A-ethylene oxide (4 mol) adduct di(meth)acrylate (log P = 5.15), bisphenol A-propylene oxide (2 mol) adduct di(meth)acrylate (log P = 6.10), bisphenol A-propylene oxide (4 mol) adduct di(meth)acrylate (log P = 6.43), 9,9-bis[4-(2-(meth) acryloyloxyethoxy)phenyl]fluorene (log P = 7.48), or p-phenylphenol(meth)acrylate (log P = 3.98).

When the polyfunctional radically polymerizable compound and the monofunctional radically polymerizable compound are used in combination, the content rate of the polyfunctional radically polymerizable compound is preferably 20 to 97 weight%, more preferably 50 to 95 weight%, further preferably 75 to 92 weight%, particularly preferably 80 to 92 weight%, with respect to the total amount of the radically polymerizable compounds. As long as the content rate falls within such a range, it is possible to obtain a polarizing film which is excellent in terms of durability under high temperature and high humidity.

Examples of the monofunctional radically polymerizable compound include a (meth)acrylamide derivative having a (meth)acrylamide group. By using the (meth)acrylamide derivative, it becomes possible to form an adhesion layer which is excellent in terms of adherence property, with high productivity. Specific examples of the (meth)acrylamide derivative include: an N-alkyl group-containing (meth)acrylamide derivative such as N-methyl(meth)acrylamide, N,N-dimethyl(meth)acrylamide, N,N-diethyl(meth)acrylamide, N-isopropyl(meth)acrylamide, N-butyl(meth)acrylamide, or N-hexyl(meth)acrylamide; an N-hydroxyalkyl group-containing (meth)acrylamide derivative such as N-methylol(meth)acrylamide, N-hydroxyethyl(meth)acrylamide, or N-methylol-N-propane(meth)acrylamide; an N-aminoalkyl group-containing (meth)acrylamide derivative such as aminomethyl(meth) acrylamide or aminoethyl(meth)acrylamide; an N-alkoxy group-containing (meth)acrylamide derivative such as N-methoxymethylacrylamide or N-ethoxymethylacrylamide; and an N-mercaptoalkyl group-containing (meth)acrylamide derivative such as mercaptomethyl(meth)acrylamide or mercaptoethyl(meth)acrylamide. Further, as a heterocycle-containing (meth)acrylamide derivative in which an nitrogen atom of a (meth)acrylamide group forms a heterocycle, it is possible to use, e.g., N-acryloylmorpholine, N-acryloylpiperidine, N-methacryloylpiperidine, or N-acryloylpyrrolidine. Among them, the N-hydroxyalkyl group-containing (meth)acrylamide derivative is preferable, and N-hydroxyethyl(meth)acrylamide is more preferable.

Further, as the monofunctional radically polymerizable compound, it is possible to use, e.g. a (meth)acrylic acid derivative having a (meth)acryloyloxy group; a carboxy group-containing monomer such as (meth)acrylic acid, carboxyethyl acrylate, carboxypentyl acrylate, itaconic acid, maleic acid, fumaric acid, crotonic acid, or isocrotonic acid; a lactam-based vinyl monomer such as N-vinylpyrrolidone, N-vinyl-ε -caprolactam, or methylvinylpyrrolidone; and a vinyl-based monomer having a nitrogen-containing heterocycle, such as vinylpyridine, vinylpiperidone, vinylpyrimidine, vinylpiperazine, vinylpyrazine, vinylpyrrole, vinylimidazole, vinyloxazole, or vinylmorpholine.

When the polyfunctional radically polymerizable compound and the monofunctional radically polymerizable compound are used in combination, the content rate of the monofunctional radically polymerizable compound is preferably 3 to 80 weight%, more preferably 5 to 50 weight%, further preferably 8 to 25 weight%, particularly preferably 8 to 20 weight%, with respect to the total amount of the radically polymerizable compounds. As long as the content rate falls within such a range, it is possible to obtain a polarizing plate which is excellent in terms of durability under high temperature and high humidity.

The radical polymerization-curable adhesive may further contain any other additive. In a case where the radical polymerization-curable adhesive contains a curable compound which is curable by active energy rays, the adhesive may further contain, e.g., a photopolymerization initiator, a photoacid generator, or a silane coupling agent. Further, in a case where the radical polymerization-curable adhesive contains a curable compound which is curable by heat, the adhesive may further contain, e.g., a thermal polymerization initiator or a silane coupling agent. Examples of other additives include a polymerization inhibitor, a polymerization initiation aid, a leveling agent, a wettability improver, a surfactant, a plasticizer, a UV absorber, an inorganic filler, a pigment, and a dye.

(Cationic Polymerization-Curable Adhesive)

The cationic polymerization-curable adhesive contains a cationically polymerizable compound as the curable compound. Examples of the cationically polymerizable compound include a compound having an epoxy group and/or an oxetanyl group. As the compound having an epoxy group, it is preferable to use a compound having at least two epoxy groups in the molecule. Examples of the compound having an epoxy group include: a compound having at least two epoxy groups and at least one aromatic ring (aromatic epoxy compound); and a compound having at least two epoxy groups in the molecule, at least one of which is formed between two adjacent carbon atoms constituting an alicyclic ring (alicyclic epoxy compound).

The cationic polymerization-curable adhesive preferably contains a photocationic polymerization initiator. The photocationic polymerization initiator is capable of generating a cationic species or a Lewis acid through irradiation with active energy rays such as visible light, UV light, X-rays, or an electron beam, thereby initiating a polymerization reaction of an epoxy group or an oxetanyl group. Further, the cationic polymerization-curable adhesive may further contain the aforementioned additive.

(Aqueous Adhesive)

As the aqueous adhesive, an aqueous solution (e.g., solid content concentration: 0.5 to 60 weight%) of an aqueous adhesive such as an isocyanate-based adhesive, a PVA-based adhesive, a gelatin-based adhesive, a vinyl-based latex, or an aqueous polyurethane is preferably used.

The application of the adhesive may be performed with respect to one or both of any adjacent two of the polarizing film 120, the polarizing film-protective films 121, 122, and the additional optical film. Generally, a method is preferable which comprises immersing the polarizing film in an adhesive aqueous solution, and then laminating it to the polarizing film-protective films 121, 122 by using a roll laminator or the like. The thickness of the adhesive is, but not particularly limited to, about 30 to 100 nm as measured after drying.

After the polarizing film, the polarizing film-protective films and the additional optical film are laminated together through the adhesive, the resulting laminate is subjected to the drying process. This laminate drying process is performed for the purpose of drying and solidifying the adhesive, and additionally reducing the water content for improving initial optical properties of the polarizing film laminate. As a drying method, drying by heating is commonly used. As a drying condition, a drying temperature is preferably set in the range 50 to 95°C, more preferably in the range 60 to 85°C.

The drying condition of the laminate is not particularly limited. However, in view of the efficiency and practicality of the drying, the drying temperature is preferably 50°C or more. Further, from a viewpoint of uniforming optical properties of the polarizing film laminate, it is preferably 95°C or less. The drying may be implemented while the drying temperature is raised stepwisely within the above temperature range.

The drying of the laminate may be performed successively with respect to the bonding of the polarizing film, the polarizing film-protective films and the additional optical film. Alternatively, after winding the laminate of the polarizing film, the polarizing film-protective films and the additional optical film, in a roll form, the drying may be performed as a separate process.

Generally, in order to reduce the water content of the polarizing film laminate, high-temperature and long-time drying conditions are required. The high-temperature and long-time drying is preferable from the viewpoint of reducing the water content of the polarizing film laminate, and is, on the other hand, likely to lead to deterioration in optical properties or the like of the polarizing film laminate. By using a polarizing film-protective film having a small saturated water absorption, or a polarizing film-protective film having a high water vapor permeability, it becomes possible to adjust the water content of the polarizing film laminate in the aforementioned desired range, without employing harsh drying conditions.

2-5. Pressure-Sensitive Adhesive

The adhesives described in the "1-3. Transparent Adhesives" may also be used.

3. Reliability Evaluation Items

The plurality of phenomena which are likely to occur in the polarizing film laminate, i.e., the polyene formation, the color loss and the heat-caused red discoloration, will be evaluated. Although the mechanism of the occurrence of each of the phenomena is not exactly clear, it can be probably presumed as follows.

< Polyene Formation >

In a high temperature and high humidity environment, the single transmittance of the polarizing film laminate decreases. This decrease is presumed to be caused by formation of polyene from PVA. The polyene means $-(CH = CH)_n-$, which can be formed in the polarizing film by heating. The polyene causes a significant decrease in transmittance of the polarizing film. Further, in the high temperature and high humidity environment, a PVA-polyiodine complex is more likely to be disassembled, thereby forming $I^-$ or $I_2$.

The polyene formation is considered to occur as a result of a situation where a dehydration reaction is promoted by iodine ($I_2$) formed in the high temperature and high humidity environment and heating, as shown in the following chemical formula 1.

(Chemical Formula 1)

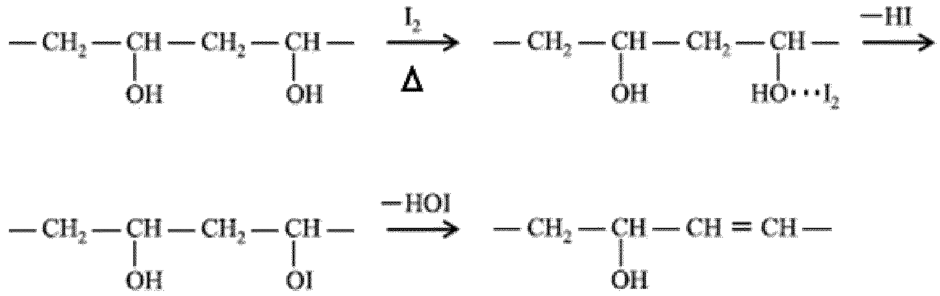


It is considered that $I_2$ arising as a result of a situation where a PVA-polyiodine complex existing in the polarizing film is disassembled by heating, and an OH group form a charge-transfer complex (HO - - - $I_2$), and then the charge-transfer complex is formed as polyene through an OI group.

< Color Loss >

In the iodine-dyed and stretched PVA-based film (polarizing film), iodine forms a complex in cooperation with molecularly oriented PVA, in the form of polyiodine ions of $I_3^-$ and $I_5^-$ (PVA-polyiodine complex). In this state, cross-linking points are formed in PVA by a cross-linking agent such as boric acid, thereby maintaining an orientation property of the PVA.

However, when the polarizing film is placed in the high temperature and high humidity environment, the orientation property of the PVA is deteriorated, causing disassembly of the PVA-polyiodine complex. This leads to deterioration in visual light absorption based on the PVA-polyiodine complex, and thereby the transmittance on the long wavelength side with respect to about 700 nm and on the short wavelength side with respect to about 410 nm rises. Thus, in a situation where the polarizing film is placed under high temperature and high humidity, the color loss occurs in a black display state.

< Heat-Caused Red Discoloration >

In the iodine-dyed and stretched PVA-based film (polarizing film), iodine forms a complex in cooperation with PVA, in the form of polyiodine ions of $I_3^-$ and $I_5^-$ (PVA-polyiodine complex). $I_3^-$ has an absorption peak around 470 nm, and $I_5^-$ has an absorption peak around 600 nm. That is, a PVA-$I_3^-$ complex undertakes a roll of absorbing the short wavelength-side (blue-side) light, and a PVA-$I_5^-$ complex undertakes a roll of absorbing the long wavelength-side (red-side) light.

However, the PVA-$I_5^-$ complex is weak against heating. Thus, when the polarizing film is placed under high temperature, the PVA-$I_5^-$ complex is disassembled, and $I_5^-$ is broken.

Therefore, in the polarizing film placed under high temperature, the PVA-$I_5^-$ complex undertaking the roll of absorbing the long wavelength-side light decreases, i.e. the transmittance on the long wave side with respect to about 700 nm rises, so that the polarizing film is discolored to red.

4. Inventive Examples and Comparative Examples

Although Inventive Example will be described along with Comparative Examples, it is to be understood that the present invention is not limited to contents described in Inventive Examples.

As Inventive Examples and Comparative Examples, samples of various polarizing film laminates which are different from each other in terms of "the film thickness (μm) of a polarizing film", and/or "the iodine concentration (wt.%) of the polarizing film", and/or "the water content (g/m$^2$) of a polarizing film laminate" were prepared.

< Film Thickness of Polarizing Film >

The film thickness (μm) of a polarizing film is measured using a spectroscopic film thickness meter MCPD-1000 (manufactured by Otsuka Electronics Co., Ltd.). The thickness of a polarizing film-protective film is also measured using this meter. The polarizing film comprised in each sample can be taken out by immersing the sample in a solvent to dissolve polarizing film-protective films in the solvent. As the solvent, it is possible to use dichloromethane, cyclohexane, and methyl ethyl ketone when each of the polarizing film-protective films is formed of a triacetylcellulose resin, a cycloolefin

resin, and an acrylic resin, respectively. In a case where a resin of the polarizing film-protective film provided on one of opposite surface of the polarizing film is different from that of the polarizing film-protective film provided on the other surface of the polarizing film, these resins may be sequentially dissolved using two of the above solvents.

< Iodine Concentration of Polarizing Film >

The iodine concentration (wt.%) of the polarizing film can be changed, e.g., by adjusting the concentration of an iodine aqueous solution in which a PVA-based film or PVA layer is to be immersed, and/or a time period of the immersion, during manufacturing of the polarizing plate.

The iodine concentration of the polarizing film is measured in the following manner. Here, the polarizing film comprised in each sample can be taken out by immersing the sample in a solvent to dissolve the polarizing film-protective films in the solvent, in the same manner as that in the measurement of the film thickness of the polarizing film.

(Fluorescent X-ray Measurement)

To prepare for measuring the iodine concentration of the polarizing film, the iodine concentration is quantitatively determined using a calibration curve method for fluorescent X-ray analysis. As a measurement device, a fluorescent X-ray analyzer ZSX-PRIMUS IV (manufactured by Rigaku Corporation) is used.

A value to be directly obtained by the fluorescent X-ray analyzer is not the concentration of each element, but a fluorescent X-ray intensity (kcps) at a wavelength unique to each element. Thus, in order to determine the concentration of iodine contained in the polarizing film, it is necessary to convert the fluorescent X-ray intensity to the concentration, using a calibration curve. The term "iodine concentration of a polarizing film" here means an iodine concentration (wt.%) on the basis of the weight of the polarizing film.

(Creation of Calibration Curve)

The calibration curve is created in the following steps.
1. A known amount of potassium iodide is dissolved in a PVA aqueous solution to produce 7 types of PVA aqueous solutions each containing iodine in a known concentration. Each of the PVA aqueous solutions is applied onto polyethylene terephthalate, and, after drying, peeled off, to produce samples 1 to 7 of PVA films each containing iodine in a known concentration.
Here, the iodine concentration (wt.%) of each PVA film is calculated by the following mathematical formula 1.

[Mathematical Formula 1]

$$\text{Iodine concentration (wt.\%)} = \{\text{potassium iodide amount (g)} / (\text{potassium iodide amount (g)} + \text{PVA amount})\} \times (127/166)$$

(Molecular weight of iodine: 127, Molecular weight of potassium: 39)
2. With regard to each of the produced PVC films, the fluorescent X-ray intensity (kcps) corresponding to iodine is measured using the fluorescent X-ray analyzer ZSX-PRIMUS IV (manufactured by Rigaku Corporation). Here, the fluorescent X-ray intensity (kcps) is defined as a peak value of a fluorescent X-ray spectrum. Further, the film thickness of each of the produced PVC films is measured using the spectroscopic film thickness meter MCPD-1000 (manufactured by Otsuka Electronics Co., Ltd.).
3. The fluorescent X-ray intensity is divided by the film thickness of the PVC film to obtain a fluorescent X-ray intensity per unit thickness of the film (kcps/μm). The iodine concentration and the per-unit thickness fluorescent X-ray intensity are shown in the following Table 1.

TABLE 1

| | Iodine Concentration (wt%) of PVA film | Fluorescent X-ray Intensity per Unit Thickness of PVA film (kcps/μm) |
|---|---|---|
| Sample 1 | 6.88 | 0.466 |
| Sample 2 | 3.44 | 0.250 |
| Sample 3 | 1.83 | 0.130 |

(continued)

| | Iodine Concentration (wt%) of PVA film | Fluorescent X-ray Intensity per Unit Thickness of PVA film (kcps/μm) |
|---|---|---|
| Sample 4 | 1.22 | 0.094 |
| Sample 5 | 0.612 | 0.039 |
| Sample 6 | 0.306 | 0.022 |
| Sample 7 | 0.0764 | 0.0055 |

4. Based on the result as shown in Table 1, the fluorescent X-ray intensity per unit thickness of the PVA film (kcps/μm) is plotted on the horizontal axis, the concentration (wt%) of iodine contained in the PVA film is plotted on the vertical axis to create a calibration curve. The created calibration curve is shown in FIG. 3. From the calibration curve, a mathematical formula for determining the iodine concentration from the fluorescent X-ray intensity per unit thickness of the PVA film is set as the following mathematical formula 2. In FIG. 3, R2 denotes a correlation coefficient.

[Mathematical Formula 2]

(Iodine concentration) (wt%) = 14.474 × (Fluorescent X-ray intensity per unit thickness of PVA film) (kcps/μm)

(Calculation of Iodine Concentration)

The fluorescent X-ray intensity obtained by the measurement of each sample is divided by the thickness to determine the per-unit thickness fluorescent X-ray intensity (kcps/μm). The per-unit thickness fluorescent X-ray intensity of each sample is assigned to the mathematical formula 2 to determine the iodine concentration.

< Water Content of Polarizing Film Laminate >

The water content (g/$m^2$) of the polarizing film laminate can be determined by mainly adjusting the film thickness of the polarizing film, and the material, thickness, etc., of the polarizing film-protective film to be bonded to the polarizing film. It can also be adjusted by the cross-linking process (the content of boracic acid, etc.) during manufacturing of the polarizing film.

The water content of the polarizing film laminate is measured in the following manner.

First of all, the polarizing film laminate obtained in each of Inventive and Comparative Examples is cut into a square piece having a size of 0.1 m × 0.1 m.

The cut sample is put in a thermo-hygrostat, and left in an environment having a temperature of 23°C and a relative humidity of 55% for 48 hours. Subsequently, in a clean room set in the same environment of the thermo-hygrostat, i.e., at a temperature of 23°C and a relative humidity of 55%, the sample is extracted from the thermo-hygrostat, and the weight of the sample is measured within 5 minutes after the extraction. The weight of the sample at that time is defined as an initial weight W1 (g). Here, even if the temperature of the inside of the clean room fluctuates by about 2°C to 3°C, and the relative humidity of the inside of the clean room fluctuates by about ± 10%, such fluctuations do not exert any substantial influence on the initial weight, as long as the elapsed time period after the extraction falls within about 15 minutes.

Then, the extracted sample is put in a dry oven, and dried at 120°C for 2 hours. Subsequently, in the above clean room set at a temperature of 23°C and a relative humidity of 55%, the dried sample is extracted from the dry oven, and the weight of the sample is measured within 10 minutes after the extraction. The weight of the sample at that time is defined as a post-drying weight W2 (g). Differently from the above, the elapsed time period is set to within 10 minutes, instead of within 5 munities, because a cooling time period is taken into account. In this case, as with the above, as long as the elapsed time period after the extraction falls within about 15 minutes, the fluctuations do not exert any substantial influence on the post-drying weight,

Then, an equilibrium water content M (g/$m^2$) is calculated by the following formula using the initial weight W1 and the post-drying weight W2 of the sample obtained in the above manner.

$$M = (W1 - W2) / (0.1 \times 0.1)$$

The term "water content of the polarizing film laminate" here means the equilibrium water content calculated in the above manner.

[Inventive Example 1]

(Production of Polarizing Film)

An elongate-shaped amorphous isophthalic acid-copolymerized polyethylene terephthalate (isophthalic acid group modification degree: 5 mol%, thickness: 100 μm) was used as a resin substrate (modification degree = ethylene isophthalate unit / (ethylene terephthalate unit + ethylene isophthalate unit)). One surface of the resin substrate was subjected to corona treatment (treatment condition: 55 W·min/$m^2$), and an aqueous solution obtained by adding potassium iodide to PVA containing a combination of 90 weight parts of PVA (polymerization degree: 4,200, saponification degree: 99.2 mol %) and 10 weight parts of acetoacetyl-modified PVA (trade name "GOHSEFIMER Z410", manufactured by the Nippon Synthetic Chemical Industry Co., Ltd.), in an amount of 13 weight parts with respect to the amount of the PVA, was applied to the corona-treated surface at normal temperature. Subsequently, the applied solution was dried at 60°C to form a 13 μm-thick PVA-based resin layer, thereby producing a laminate.

The obtained laminate was subjected to free-end uniaxial stretching, in such a manner as to be stretched in a longitudinal direction (lengthwise direction) thereof, between rolls having different peripheral speeds in an oven at 130°C, to attain a stretch ratio of 2.0 (in-air auxiliary stretching process).

Subsequently, the laminate was immersed in an insolubilization bath (a boric acid aqueous solution obtained by adding 4 weight parts of boric acid to 100 weight parts of water) having a solution temperature of 40°C for 30 seconds (insolubilization process).

Subsequently, the laminate was immersed in a dyeing bath (an iodine aqueous solution obtained by adding iodine and potassium iodide mixed at a weight ratio of 1 : 7 to 100 weight parts of water) having a solution temperature of 30°C, for 60 seconds, while the concentrations of them were adjusted to attain a designated transmittance, (dyeing process).

Subsequently, the laminate was immersed in a cross-linking bath (a boric acid aqueous solution obtained by adding 3 weight parts of potassium iodide and 3 weight parts of boric acid to 100 weight parts of water) having a solution temperature of 40°C for 30 seconds (cross-linking process).

Subsequently, while the laminate was immersed in a boric acid aqueous solution (boric acid concentration: 3.0 weight%) having a solution temperature of 70°C, the laminate was subjected to uniaxial stretching, in such a manner as to be stretched in the longitudinal direction (lengthwise direction) between rolls having different peripheral speeds, to attain a total stretch ratio of 5.5 (in-boric-acid-solution stretching process).

Subsequently, the laminate was immersed in a washing bath (an aqueous solution obtained by adding 4 weight parts of potassium iodide to 100 weight parts of water) having a solution temperature of 20°C (washing process).

Subsequently, while the laminate is dried in an oven kept at 90°C (drying process), the laminate was brought into contact with a metal roll made of SUS and having a surface temperature kept at 75°C for 2 seconds or more (heated roll drying process).

In this manner, a 5.4 μm-thick polarizing film was obtained on the resin substrate.

(Production of Polarizing Film Laminate)

A cycloolefin-based film (ZT12, manufactured by Zeon Corporation, 18 μm) was bonded, as the polarizing film-protective film, to a surface of the obtained polarizing film on the side opposite to the resin substrate, through an ultraviolet curable adhesive. Specifically, the after-mentioned curable adhesive was applied to allow a final thickness to become 1.0 μm, and the cycloolefin-based film is bonded using a roll machine. Subsequently, UV light was emitted from the side of the cycloolefin-based film to cure the adhesive. Subsequently, the resin substrate was peeled off to obtain a polarizing film laminate comprising the cycloolefin-based polarizing film-protective film and the polarizing film.

The details of the curable adhesive are as follows. 40 weight parts of N-hydroxyethyl acrylamide (HEAA), 60 weight parts of acryloyl morpholine (ACMO) and 3 weight parts of a photoinitiator "IRGACURE 819" (manufactured by BASF SE) were mixed to prepare an adhesive. This adhesive was applied onto the polarizing film to allow the thickness of an adhesive layer after curing to become 1.0 μm, and irradiated and cured with ultraviolet light as active energy energy rays. The ultraviolet irradiation was performed using a gallium-sealed metal halide lamp, an irradiation device: Light HAMMER 10, manufactured by Fusion UV Systems, Inc. (bulb: V bulb, peak irradiance: 1600 mW/$cm^2$, cumulative dose:

1000 mJ/cm$^2$ (wavelengths: 380 to 440 nm)). The illuminance of the ultraviolet light was measured using a Sola-Check system manufactured by Solatell Ltd.

(Extraction of Polarizing Film)

The polarizing film was extracted from the polarizing film-protective film by using cyclohexane as a solvent, and the iodine concentration of the extracted polarizing plate was measured.

[Inventive Example 2]

In the production of the polarizing film in Inventive Example 1, the concentration of the iodine aqueous solution and the immersion time period in the dyeing process were adjusted to change the iodine concentration. Further, the thickness of the polarizing film-protective film was adjusted to change the water content of the polarizing film laminate. The remaining conditions were the same as those in Inventive Example 1.

[Inventive Example 3]

In the production of the polarizing film in Inventive Example 1, the concentration of the iodine aqueous solution and the immersion time period in the dyeing process were adjusted to change the iodine concentration. Further, the thickness of the polarizing film-protective film was adjusted to change the water content of the polarizing film laminate. Further, in the production of the polarizing film laminate in Inventive Example 1, a cycloolefin-based film (ZF12, manufactured by Zeon Corporation, 13 μm) was bonded, as the polarizing film-protective film. The remaining conditions were the same as those in Inventive Example 1.

[Inventive Example 4]

In the production of the polarizing film laminate in Inventive Example 1, a triacetyl cellulose film-based film (TJ40UL, manufactured by FUJIFILM Corporation, thickness: 40 μm) was bonded, as the polarizing film-protective film. Further, in the production of the polarizing film in Inventive Example 1, the concentration of the iodine aqueous solution and the immersion time period in the dyeing process were adjusted to change the iodine concentration. The remaining conditions were the same as those in Inventive Example 1.

[Inventive Example 5]

In the production of the polarizing film laminate in Inventive Example 1, a 40 μm-thick transparent protective film (manufactured by Nitto Denko Corporation) comprised of a modified acrylic polymer having a lactone ring structure was bonded, as the polarizing film-protective film. Further, in the production of the polarizing film in Inventive Example 1, the concentration of the iodine aqueous solution and the immersion time period in the dyeing process were adjusted to change the iodine concentration. The remaining conditions were the same as those in Inventive Example 1.

[Inventive Example 6]

(Production of Polarizing Film)

A 30 μm-thick PVA film having an average polymerization degree of 2,700 was conveyed while being dyed and stretched between rolls having different peripheral speed ratios. Firstly, the PVA film was stretched in a conveyance direction thereof to attain a stretch ratio of 1.2, while being immersed and swelled in a water bath at 30°C for 1 minute, and then stretched in the conveyance direction to attain a stretch ratio of 3 (on the basis of an unstretched state of the PVA film), while being immersed in and dyed by an aqueous solution (solution temperature: 30°C) of potassium iodide (0.03 weight%) and iodine (0.3 weight%) for 1 minute. Subsequently, the stretched film was stretched in the conveyance direction to attain a stretch ratio of 6 (on the basis of the unstretched state of the PVA film), while being immersed in an aqueous solution (bath solution) of boric acid (4 weight%), potassium iodide (5 weight%) and zinc sulfate (3.5 weight%) for 30 seconds. After the stretching, the stretched film was dried in an oven at 40°C for 3 minutes to obtain a 12 μm-thick polarizing film.

(Production of Polarizing Film Laminate)

As an adhesive, an aqueous solution containing an acetoacetyl group-containing polyvinyl alcohol resin (average polymerization degree: 1200, saponification degree: 98.5 mol%, acetoacetylation degree: 5 mol%), and methylol melamine at a weight ratio of 3 : 1 was used. Using this adhesive and under a temperature condition of 30°C, a 20 μm-thick transparent protective film (manufactured by Nitto Denko Corporation) comprised of a modified acrylic polymer having a lactone ring structure, and a 27 μm-thick transparent protective film obtained by forming a 2 μm-thick hard coat layer (HC) on a 25 μm-thick triacetyl cellulose film (trade name "KC2UA", manufactured by Konica Minolta, Inc.) were bonded, respectively, to one of opposite surfaces and the other surface of the polarizing film by using a roll laminator. Subsequently, the resulting laminate was heated and dried in an oven at 70°C for 5 minutes to obtain a polarizing film laminate having the transparent protective films bonded, respectively, to the opposite surfaces thereof.

The hard coat layer was formed in the following manner. Firstly, a hard coat layer-forming material was prepared. This hard coat layer-forming material was produced by adding, to a resin solution (trade name "UNIDIC 17-806", manufactured by DIC Corporation, solid content concentration: 80%) obtained by dissolving a UV-curable resin monomer or oligomer consisting mainly of urethane acrylate, in butyl acetate, 5 weight parts of a photopolymerization initiator (product name "IRGACURE 906", manufactured by BASF SE) and 0.01 weight part of a leveling agent (product name "GRANDIC PC4100", manufactured by DIC Corporation) per 100 weight parts of a solid content in the solution, and then adding, to the resulting mixed solution, cyclopentanone (hereinafter expressed to as "CPN") and propylene glycol monomethyl ether (hereinafter expressed as "PGM") at a ratio of 45:55 to allow the solid content concentration in the solution to become 36 weight%. The hard coat layer-forming material produced in the above manner was applied onto a transparent protective film to allow the thickness of a hard coat after curing to become 2 μm, thereby forming a coating film. Then, the coating film was dried at 90°C for 1 minute, and then subjected to curing process by means of irradiation with ultraviolet light from a high-pressure mercury lamp in a cumulative dose of 300 mJ/cm$^2$.

(Extraction of Polarizing Film)

The polarizing film was extracted from the polarizing film-protective film by using dichloromethane and methyl ethyl ketone as a solvent, and the iodine concentration of the extracted polarizing plate was measured.

[Inventive Example 7]

In the production of the polarizing film in Inventive Example 6, the concentration of the iodine aqueous solution and the immersion time period in the dyeing process were adjusted to change the iodine concentration. Further, in the production of the polarizing film laminate in Inventive Example 6, as the polarizing film-protective films, a 30 μm-thick transparent protective film (manufactured by Nitto Denko Corporation) comprised of a modified acrylic polymer having a lactone ring structure, and a 49 μm-thick transparent protective film obtained by forming a 9 μm-thick HC on a 40 μm-thick triacetyl cellulose film (trade name "KC4UY", manufactured by Konica Minolta, Inc.) were bonded, respectively, to one surface and the other surface of the obtained polarizing film. The remaining conditions were the same as those in Inventive Example 6.

[Inventive Example 8]

In the production of the polarizing film in Inventive Example 6, a 45 μm-thick PVA film was conveyed and stretched in the stretching process to obtain an 18.0 μm-thick polarizing film, and the concentration of the iodine aqueous solution and the immersion time period in the dyeing process were adjusted to change the iodine concentration. Further, in the production of the polarizing film laminate in Inventive Example 6, as the polarizing film-protective films, a 30 μm-thick transparent protective film (manufactured by Nitto Denko Corporation) comprised of a modified acrylic polymer having a lactone ring structure, and a triacetyl cellulose film-based film ("TJ40UL", manufactured by FUJIFILM Corporation, thickness: 40 μm) were bonded, respectively, to one surface and the other surface of the obtained polarizing film. The remaining conditions were the same as those in Inventive Example 6.

[Inventive Example 9] to [Inventive Example 14]

In the production of the polarizing film in Inventive Example 8, the concentration of the iodine aqueous solution and the immersion time period in the dyeing process were adjusted to change the iodine concentration. Further, the thickness of the polarizing film-protective film was adjusted to change the water content of the polarizing film laminate. The remaining conditions were the same as those in Inventive Example 8.

[Comparative Example 1] and [Comparative Example 2]

In the production of the polarizing film in Inventive Example 1, the concentration of the iodine aqueous solution

and the immersion time period in the dyeing process were adjusted to change the iodine concentration. Further, the thickness of the polarizing film-protective film was adjusted to change the water content of the polarizing film laminate. The remaining conditions were the same as those in Inventive Example 1.

[Comparative Example 3]

In the production of the polarizing film laminate in Inventive Example 1, a cycloolefin-based film (ZD12, manufactured by Zeon Corporation, 27 μm) was bonded, as the polarizing film-protective film. Further, the concentration of the iodine aqueous solution and the immersion time period in the dyeing process were adjusted to change the iodine concentration, and the thickness of the polarizing film-protective film was adjusted to change the water content of the polarizing film laminate. The remaining conditions were the same as those in Inventive Example 1.

[Comparative Example 4]

In the production of the polarizing film in Inventive Example 1, the concentration of the iodine aqueous solution and the immersion time period in the dyeing process were adjusted to change the iodine concentration. Further, the thickness of the polarizing film-protective film was adjusted to change the water content of the polarizing film laminate. The remaining conditions were the same as those in Comparative Example 3.

[Comparative Example 5]

In the production of the polarizing film in Inventive Example 1, a laminate formed with a 10 μm-thick PVA-based resin layer was subjected to, e.g., the in-air auxiliary stretching and the in-boric-acid-solution stretching, to obtain a 4.0 μm-thick polarizing film. Further, in the production of the polarizing film laminate in Inventive Example 1, a cycloolefin-based film (ZD12, manufactured by Zeon Corporation, 27 μm) was bonded, as the polarizing film-protective film. Further, the concentration of the iodine aqueous solution and the immersion time period in the dyeing process were adjusted to change the iodine concentration, and the thickness of the polarizing film-protective film was adjusted to change the water content of the polarizing film laminate. The remaining conditions were the same as those in Inventive Example 1.

[Comparative Example 6]

In the production of the polarizing film in Inventive Example 6, the concentration of the iodine aqueous solution and the immersion time period in the dyeing process were adjusted to change the iodine concentration. Further, the thickness of the polarizing film-protective film was adjusted to change the water content of the polarizing film laminate. The remaining conditions were the same as those in Inventive Example 6.

[Comparative Example 7]

In the production of the polarizing film in Inventive Example 7, the concentration of the iodine aqueous solution and the immersion time period in the dyeing process were adjusted to change the iodine concentration. Further, the thickness of the polarizing film-protective film was adjusted to change the water content of the polarizing film laminate. The remaining conditions were the same as those in Inventive Example 7.

[Comparative Example 8] to [Comparative Example 11]

In the production of the polarizing film in Inventive Example 6, the concentration of the iodine aqueous solution and the immersion time period in the dyeing process were adjusted to change the iodine concentration. Further, the thickness of the polarizing film-protective film was adjusted to change the water content of the polarizing film laminate. The remaining conditions were the same as those in Inventive Example 6.

[Comparative Example 12]

In the production of the polarizing films in Inventive Examples 8 to 14, the concentration of the iodine aqueous solution and the immersion time period in the dyeing process were adjusted to change the iodine concentration. Further, the thickness of the polarizing film-protective film was adjusted to change the water content of the polarizing film laminate. The remaining conditions were the same as those in Inventive Examples 8 to 14.

[Comparative Example 13]

(Production of Polarizing Film)

In the production of the polarizing films in Inventive Examples 8 to 14, a 60 μm-thick PVA film was conveyed and stretched in the stretching process to obtain a 22.0 μm-thick polarizing film. Further, the concentration of the iodine aqueous solution and the immersion time period in the dyeing process were adjusted to change the iodine concentration, and the thickness of the polarizing film-protective film was adjusted to change the water content of the polarizing film laminate. The remaining conditions were the same as those in Inventive Examples 8 to 14.

(Production of Polarizing Film Laminate)

As the polarizing film-protective films, a 30 μm-thick transparent protective film (manufactured by Nitto Denko Corporation) comprised of a modified acrylic polymer having a lactone ring structure, and a 49 μm-thick transparent protective film obtained by forming a 9 μm-thick HC on a 40 μm-thick triacetyl cellulose film (trade name "KC4UY", manufactured by Konica Minolta, Inc.) were bonded, respectively, to one surface and the other surface of the obtained polarizing film. The remaining processes were the same as those in Inventive Examples 8 to 14.

(Extraction of Polarizing Film)

The extraction conditions were the same as those in Inventive Examples 8 to 14.

[Comparative Example 14]

In the production of the polarizing film in Comparative Example 13, the concentration of the iodine aqueous solution and the immersion time period in the dyeing process were adjusted to change the iodine concentration. Further, the thickness of the polarizing film-protective film was adjusted to change the water content of the polarizing film laminate. Further, a 20 μm-thick transparent protective film (manufactured by Nitto Denko Corporation) comprised of a modified acrylic polymer having a lactone ring structure was bonded, as the polarizing film-protective film, to one surface of the polarizing film. The remaining conditions were the same as those in Comparative Example 13.

[Comparative Example 15]

In the production of the polarizing films in Inventive Examples 8 to 14, a 75 μm-thick PVA film was conveyed and stretched in the stretching process to obtain a 28 μm-thick polarizing film. Further, the concentration of the iodine aqueous solution and the immersion time period in the dyeing process were adjusted to change the iodine concentration, and the thickness of the polarizing film-protective film was adjusted to change the water content of the polarizing film laminate. The remaining conditions were the same as those in Inventive Examples 8 to 14.

4-1. Reliability Test

Two glass plates (microscope slides manufactured by Matsunami Glass Ind. Ltd., part number: S2000423, spec.: water ground-edge 65 × 165 mm, thickness: 1.3 mm) were laminated, respectively, to opposite surfaces of each of the polarizing film laminates 12 obtained in Inventive and Comparative Examples, as shown in FIG. 4, through pressure-sensitive adhesives 11, 13, to prepare a sample.

As the pressure-sensitive adhesives, CS9868US (manufactured by Nitto Denko Corporation) having a thickness of 200 μm was used for one surface of the polarizing film laminate, and an acrylic pressure-sensitive adhesive (thickness: 20 μm) used for a polarizing film laminate CRT1794YCU (manufactured by Nitto Denko Corporation) was used for the other surface of the polarizing film laminate. The acrylic pressure-sensitive adhesive used for the other surface was obtained in the following manner. In a reaction container equipped with a cooling tube, a nitrogen introduction tube, a thermometer and a stirring device, 99 weight parts (hereinafter referred to simply as "part(s)) of butyl acrylate, 1.0 part of 4-hydroxylbutyl acrylate, and 0.3 parts of 2,2'-azobisisobutylonitrile were put, together with ethyl acetate, to induce a reaction at 60°C for 4 hours under a nitrogen gas stream, and then ethyl acetate was added to the resulting reaction solution to obtain a solution (concentration of a solid content: 30 weight%) containing an acrylic polymer having a weight-average molecular weight of 1,650,000. Then, with respect to 100 parts of a solid content of the acrylic polymer solution, 0.3 parts of dibenzoylperoxide (NOF Corporation: Nyper BMT), 0.1 parts of trimethylolpropane xylenediisocyanate (Mitsui Chemicals Polyurethanes Inc.: Takenate D110N), and 0.2 parts of a silane coupling agent (Soken Chemicals & Engineering Co., Ltd.: A-100, an acetoacetyl group-containing silane coupling agent) were mixed together to obtain the acrylic

pressure-sensitive adhesive.

After leaving the sample at 95°C for 250 hours (95°C/250 H), it was evaluated in terms of the color loss and the heat-caused red discoloration, and, after leaving the sample at 95°C for 500 hours (95°C/500 H), it was evaluated in terms of the polyene formation.

4-2. Evaluation Criteria

The evaluation criterion of each of the polyene formation, the color loss and the heat-caused red discoloration are shown below.

< Polyene Formation >

The single transmittance of each sample was measured before and after the 95°C/500 H heating test, and the amount of change ΔTs in the single transmittance was determined by the following formula:

$$\text{(Formula)} \qquad \Delta Ts = \Delta Ts_{500} - Ts_0$$

where Tso indicates the single transmittance of the sample which was measured before heating, while $\Delta T_{S500}$ indicates the single transmittance thereof which was measured after 95°C/500 H heating.

When the change amount ΔTs has a negative value, the sample was evaluated as "polyene formation (decrease in the single transmittance)". In other words, when the single transmittance after heating of 95°C/500 H is equal to or greater than the single transmittance before the heating, the sample was evaluated as having no problem regarding the polyene formation.

With regard to each sample, the single transmittance was measured using a spectrophotometer (product name "DOT-3", manufactured by Murakami Color Research Laboratory Co., Ltd.). Here, the single transmittance can be determined according to JIS Z 8701.

< Color Loss • Heat-Caused Red Discoloration >

In a state in which each sample was arranged in a crossed-nicols state, crossed transmittances (%) at a wavelength of 410 nm and a wavelength of 700 nm were measured before and after the 95°C/250 H heating test by the aforementioned spectrophotometer, to determine the change amounts $\Delta T_{S410}$ and $\Delta T_{S700}$ at the respective wavelengths.

The sample satisfying both the following two conditions was evaluated as having "color loss".

- Change amount $\Delta Ts_{410}$ is equal to or greater than 1%
- Change amount $\Delta Ts_{700}$ is equal to or greater than 5%

In other words, when the amount of change in the crossed transmittance at a wavelength of 410 nm due to the 95°C/500 H heating test is less than 1% and the amount of change in the crossed transmittance at a wavelength of 700 nm due to the 95°C/500 H heating test is less than 5%, the sample was evaluated as having no problem regarding the color loss.

Further, the sample satisfying the following conditions was evaluated as having "heat-caused red discoloration".

- Change amount $\Delta Ts_{410}$ is less than 1%
- Change amount $\Delta Ts_{700}$ is equal to or greater than 5%

In other words, when the amount of change in the crossed transmittance at a wavelength of 410 nm due to the 95°C/500 H heating test is equal to or greater than 1% and the amount of change in the crossed transmittance at a wavelength of 700 nm due to the 95°C/500 H heating test is less than 5%, the sample was evaluated as having no problem regarding the heat-caused red discoloration.

Results of the evaluations of Inventive and Comparative Examples are shown in the following Table 2.

[TABLE 2]

| | Film Thickness of Polarizing Film (μm) | Iodine Concent ration (wt%) | Water Content (g/m$^2$) | Result of Reliability | 95° C/500 H | 95° C/250 H | |
|---|---|---|---|---|---|---|---|
| | | | | | Amount of Change in Single Transmittance (%) | Amount of Change in Crossed Transmittance (%) at 410 nm | Amount of Change in Crossed Transmittance (%) at 700 nm |
| Inventive Example 1 | 5.4 | 8.2 | 0.99 | OK | 1.55 | -0.006 | 0.349 |
| Inventive Example 2 | 5.4 | 9.5 | 0.90 | OK | 2.31 | 0.006 | 0.007 |
| Inventive Example 3 | 5.4 | 7.1 | 0.96 | OK | 0.93 | -0.008 | 0.210 |
| Inventive Example 4 | 5.4 | 6.9 | 1.97 | OK | 0.72 | -0.009 | 0.274 |
| Inventive | 5.4 | 6.9 | 1.60 | OK | 0.90 | -0.012 | 0.352 |
| Example 5 | | | | | | | |
| Comparative Example 1 | 5.4 | 5.9 | 0.90 | Heat-caused red discoloration | 2.67 | 0.100 | 11.200 |
| Comparative Example 2 | 5.4 | 10.6 | 0.99 | Polyene formation | -0.56 | 0.005 | 0.059 |
| Comparative Example 3 | 5.4 | 3.7 | 1.03 | Heat-caused red discoloration | 2.02 | 0.119 | 7.553 |
| Comparative Example 4 | 5.4 | 2.6 | 1.03 | Heat-caused red discoloration | 6.57 | 0.297 | 14.390 |
| Comparative Example 5 | 4.0 | 5.5 | 0.83 | Heat-caused red discoloration | 7.75 | 0.615 | 17.217 |
| Inventive Example 6 | 12.0 | 3.6 | 2.83 | OK | 0.80 | 0.010 | 0.277 |
| Comparative Example 6 | 12.0 | 2.5 | 2.83 | Heat-caused red discoloration | 4.18 | 0.502 | 13.191 |
| Inventive Example 7 | 12.0 | 3.5 | 3.17 | OK | 0.62 | 0.019 | 0.233 |

(continued)

| | Film Thickness of Polarizing Film (μm) | Iodine Concentration (wt%) | Water Content ($g/m^2$) | Result of Reliability | 95° C/500 H | 95° C/250 H | |
|---|---|---|---|---|---|---|---|
| | | | | | Amount of Change in Single Transmittance (%) | Amount of Change in Crossed Transmittance (%) at 410 nm | Amount of Change in Crossed Transmittance (%) at 700 nm |
| Comparative | 12.0 | 5.5 | 3.17 | Polyene formation | -0.35 | 0.004 | 0.016 |
| Example 7 | | | | | | | |
| Comparative Example 8 | 12.0 | 5.6 | 2.94 | Polyene formation | -22.92 | -0.003 | -0.007 |
| Comparative Example 9 | 12.0 | 9.0 | 3.02 | Polyene formation | -36.72 | 0.000 | -0.001 |
| Comparative Example 10 | 12.0 | 5.3 | 2.93 | Polyene formation | -37.45 | 0.005 | 0.000 |
| Comparative Example 11 | 12.0 | 10.0 | 3.01 | Polyene formation | -35.49 | -0.004 | -0.004 |
| Inventive Example 8 | 18.0 | 3.1 | 3.91 | OK | 0.74 | 0.003 | 0.014 |
| Inventive Example 9 | 18.0 | 2.3 | 3.40 | OK | 1.13 | 0.368 | 3.410 |
| Inventive Example 10 | 18.0 | 2.4 | 3.60 | OK | 0.94 | 0.268 | 2.734 |
| Inventive Example 11 | 18.0 | 2.6 | 3.80 | OK | 0.69 | 0.071 | 0.741 |
| Inventive | 18.0 | 2.8 | 3.70 | OK | 0.78 | 0.034 | 0.252 |
| Example 12 | | | | | | | |
| Inventive Example 13 | 18.0 | 3.0 | 3.50 | OK | 0.71 | 0.018 | 0.077 |
| Inventive Example 14 | 18.0 | 3.3 | 3.60 | OK | 0.76 | 0.006 | 0.007 |

(continued)

| | Film Thickness of Polarizing Film (μm) | Iodine Concentration (wt%) | Water Content (g/m²) | Result of Reliability | 95° C/500 H | 95° C/250 H | |
|---|---|---|---|---|---|---|---|
| | | | | | Amount of Change in Single Transmittance (%) | Amount of Change in Crossed Transmittance (%) at 410 nm | Amount of Change in Crossed Transmittance (%) at 700 nm |
| Comparative Example 12 | 18.0 | 2.1 | 3.70 | Heat-caused red discoloration | 2.20 | 0.704 | 6.842 |
| Comparative Example 13 | 22.0 | 2.4 | 4.80 | Color loss →Polyene formation | -0.06 | 0.054 | 0.939 |
| Comparative Example 14 | 22.0 | 1.8 | 4.57 | Color loss | 7.28 | 1.319 | 14.930 |
| Comparative Example 15 | 28.0 | 1.9 | 4.90 | Color loss →Polyene formation | -0.77 | 0.021 | 0.106 |

5. Summary of Evaluation Result

FIG. 5 is a graph in which results of Inventive and Comparative Examples are plotted on an x-y orthogonal coordinate system. The x-axis (horizontal axis) represents the iodine concentration (weight%) of the polarizing film, and the y-axis represents the water content (g/m$^2$) of the polarizing film laminate.

(1) In view of the result of plotting and common technical knowledge, generally, when the iodine concentration is low and the water content is excessively small, the problem of the heat-caused red discoloration arising in a high temperature state is likely to occur, and, when the iodine concentration is high and the water content is excessively large, the problems of the polyene formation and the color loss is likely to occur. Further, when the iodine concentration is low and the water content is excessively large, the color loss arising in a high temperature and high humidity state is likely to occur. In this situation, the problem of the polyene formation becomes more likely to occur along with an increase in the iodine concentration. Particularly, with regard to the color loss and the polyene formation, a transition region therebetween could be seen (Comparative Examples 13, 15).
On the other hand, it is considered that, when each of the iodine concentration and the water content falls within a given region, all the heat-caused red discoloration, the polyene formation and the color loss can be comprehensively solved. For example, all the results of Inventive Examples are located above a delimiting line "α" passing through the vicinity of a plot indicative of the result of Inventive Example 3 having the smallest value of the water content, i.e., a coordinate point at which the iodine concentration is 7.0 wt% and the water content is 0.7 g/m$^2$ (this coordinate point will hereinafter be referred to as "first coordinate point"), and the vicinity of a plot indicative of the result of Inventive Example 9 having the smallest value of the iodine concentration, i.e., a coordinate point at which the iodine concentration is 2.2 wt% and the water content is 3.2 g/m$^2$ (this coordinate point will hereinafter be referred to as "second coordinate point"), i.e., y = (1043 - 125x) / 240, and located below a delimiting line "β" passing through the vicinity of a plot indicative of the result of Inventive Example 8 having the largest value of the water content, i.e., a coordinate point at which the iodine concentration is 3.0 wt% and the water content is 4.0 g/m$^2$ (this coordinate point will hereinafter be referred to as "fourth coordinate point"), and the vicinity of a plot indicative of the result of Inventive Example 2 having the largest value of the iodine concentration, i.e., a coordinate point at which the iodine concentration is 10.0 wt% and the water content is 0.7 g/m$^2$ (this coordinate point will hereinafter be referred to as "fifth coordinate point"), i.e., y = (379 - 33x) / 70. Thus, a region delimited by the delimiting lines "α" and "β" can be deemed as a line indicative of a requirement necessary for comprehensively solving all of the heat-caused red discoloration, the polyene formation and the color loss. Here, the delimiting lines "α" and "β" are applicable to any of various polarizing films, irrespective of the film thickness thereof, more specifically, any of various polarizing films having a film thickness of about 4 to 20 μm.
(2) Further, in view of the result of plotting and common technical knowledge, it can be seen that, particularly, with regard to any of various polarizing films having a film thickness of about 4 to 20 μm, all of the "polyene formation", the "color loss" and the "heat-caused red discoloration" can be comprehensively solved when the iodine concentration of the polarizing film and the water content of the polarizing film laminate fall within a region surrounded by a to e, more specifically a region surrounded by: a first line segment connecting a first coordinate point ("a" in FIG. 5) at which the iodine concentration is 7.0 wt% and the water content is 0.7 g/m$^2$, and a second coordinate point ("b" in FIG. 5) at which the iodine concentration is 2.2 wt% and the water content is 3.2 g/m$^2$; a second line segment connecting the second coordinate point "b", and a third coordinate point ("c" in FIG. 5) at which the iodine concentration is 2.2 wt% and the water content is 4.0 g/m$^2$; a third line segment connecting the third coordinate point "c", and a fourth coordinate point ("d" in FIG. 5) at which the iodine concentration is 3.0 wt% and the water content is 4.0 g/m$^2$; a fourth line segment connecting the fourth coordinate point "d", and a fifth coordinate point ("e" in FIG. 5) at which the iodine concentration is 10.0 wt% and the water content is 0.7 g/m$^2$; and a fifth line segment connecting the first coordinate point "a", and the fifth coordinate point "e".
(3) Similarly, it can be seen that, particularly, with regard to any of various polarizing films having a film thickness of about 11 to 20 μm, all of the "polyene formation", the "color loss" and the "heat-caused red discoloration" can be comprehensively solved when the iodine concentration of the polarizing film and the water content of the polarizing film laminate fall within a region surrounded by f, b, c, d, g, more specifically a region surrounded by: a sixth line segment connecting a sixth coordinate point ("f" in FIG. 5) at which the iodine concentration is 4.5 wt% and the water content is 2.0 g/m$^2$, and the second coordinate point "b"; the second line segment connecting the second coordinate point "b" and the third coordinate point "c"; the third line segment connecting the third coordinate point "c" and the fourth coordinate point "d"; a seventh line segment connecting the fourth coordinate point "d", and a seventh coordinate point ("g" in FIG. 5) at which the iodine concentration is 4.5 wt% and the water content is 3.3 g/m$^2$; and an eighth line segment connecting the sixth coordinate point "f", and the seventh coordinate point "g".
Particularly, it is considered that, when the sixth coordinate point "f" is a coordinate point "f-1" at which the iodine concentration is 4.0 wt% and the water content is 2.3 g/m$^2$, and the seventh coordinate point "g" is a coordinate

point "g-1" at which the iodine concentration is 4.0 wt% and the water content is 3.5 g/m$^2$, a preferable result can be obtained.

Further, it can be inferred that, with regard to any of various polarizing films having a film thickness of about 11 to 20 μm, good results can be obtained in terms of all of the "polyene formation", the "color loss" and the "heat-caused red discoloration", when the iodine concentration of the polarizing film and the water content of the polarizing film laminate fall within a region surrounded by f, b, c, d, g and delimited by a line segment connecting h and i, more specifically a region surrounded by: a ninth line segment connecting an eight coordinate point ("h" in FIG. 5) at which the iodine concentration is 3.3 wt% and the water amount is 2.6 g/m$^2$, and the second coordinate point "b"; the second line segment connecting the second coordinate point "b" and the third coordinate point "c"; the third line segment connecting the third coordinate point "c" and the fourth coordinate point "d"; the seventh line segment connecting the fourth coordinate point "d" and the seventh coordinate point "g"; the eighth line segment connecting the sixth coordinate point "f", and the seventh coordinate point "g"; and a tenth line segment connecting the eighth coordinate point "h", and a nine coordinate point ("i" in FIG. 5) at which the iodine concentration is 6.0 wt% and the water content is 2.6 g/m$^2$.

(4) Further, it can be seen that, particularly, with regard to any of various polarizing films having a film thickness of about 4 to 11 μm, preferably 4 to 7 μm, more preferably 4.5 to 6 μm, all of the "polyene formation", the "color loss" and the "heat-caused red discoloration" can be comprehensively solved when the iodine concentration of the polarizing film and the water content of the polarizing film laminate fall within a region surrounded by a, h, i, e, more specifically a region surrounded by: an eleventh line segment connecting the first coordinate point "a" and the eighth coordinate point "h"; the tenth line segment connecting the eighth coordinate point "h" and the ninth coordinate point "i"; a twelfth segment connecting the ninth coordinate point "i" and the fifth coordinate point "e"; and the fifth line segment connecting the first coordinate point "a" and the fifth coordinate point "e".

Particularly, it is considered that, when the eighth coordinate point "h" is the sixth coordinate point "f", and the ninth coordinate point "i" is a tenth coordinate point ("j" in FIG. 5) at which the iodine concentration is 7.2 wt% and the water content is 2.0 g/m$^2$, a preferable result can be obtained.

It can also be inferred that, with regard to any of various polarizing films having a film thickness of about 4 to 11 μm, preferably 4 to 7 μm, more preferably 4.5 to 6 μm, all of the "polyene formation", the "color loss" and the "heat-caused red discoloration" can be comprehensively solved when the iodine concentration of the polarizing film and the water content of the polarizing film laminate fall within a region surrounded by a, k, i, e, more specifically a region surrounded by: a thirteenth line segment connecting the first coordinate point "a", and an eleventh coordinate point ("k" in FIG. 5) at which the iodine concentration is 6.0 wt% and the water content is 1.2 g/m$^2$; a fourteenth line segment connecting the eleventh coordinate point "k" and the ninth coordinate point "i"; a twelfth line segment connecting the ninth coordinate point "i" and the fifth coordinate point "e"; and the fifth line segment connecting the first coordinate point "a" and the fifth coordinate point "e".

Particularly, it is considered that, when the eleventh coordinate point "k" is a coordinate point "k-1" at which the iodine concentration is 6.5 wt% and the water content is 1.0 g/m$^2$, and the ninth coordinate point "i" is a coordinate point "i-1" at which the iodine concentration is 6.5 wt% and the water content is 2.3 g/m$^2$, a more preferable result can be obtained.

## 6. Addition of Antireflective Layer

### 6-1 Layer Configuration

With a view to prevention of degradation in image quality due to reflection of external light or reflected glare of an image, improvement in contrast, etc., it is possible to add an antireflective function, as disclosed in, e.g., JP 2017-227898A. One example of a layer configuration in which the antireflective function is added to the polarizing film laminate 12 is shown in FIG. 6 in the form of a schematic diagram. In the following description, a layer element corresponding to the already-mentioned layer element will be assigned with the same reference sign as that of the already-mentioned layer element.

The antireflective function can be added by providing an antireflective film 200 on the viewing side of the polarizing film laminate 12 through a pressure-sensitive adhesive 13. The antireflective film 200 comprises a transparent substrate 201 and an antireflective layer 202 disposed on the transparent substrate 201. In this case, the transparent substrate 201 may be configured to additionally serve as a polarizing film protective film (e.g., the polarizing film-protective film 121 in the configuration in FIG. 1) constituting the optical film laminate 12.

In the antireflective layer 202, an optical film thickness (product of the refractive index and the thickness) of a thin film is adjusted such that inverted phases of incident light and reflected light cancel each other out. Examples of a material for the thin film constituting the antireflective layer 202 include an oxide, nitride, and fluoride of a metal. For

example, examples of a low refractive index material having a refractive index of 1.6 or less at a wavelength of 550 nm include a silicon oxide and a magnesium fluoride. Examples of a high refractive index material having a refractive index of 1.9 or more at a wavelength of 550 nm include a titanium oxide, a niobium oxide, a zirconium oxide, a tin-doped indium oxide (ITO), and an antimony-doped tin oxide (ATO).

Although the antireflective layer 202 may a single layer, it is preferably an alternative laminate of a low refractive index layer and a high refractive index layer. In order to reduce reflection at an air interface, a thin film to be provided as the outermost surface layer of the antireflective layer 202 is preferably a low refractive index layer. Materials for the low refractive index layer and the high refractive index layer are preferably oxides as mentioned above. Among them, the antireflective layer 202 is preferably an alternative laminate of a silicon oxide (Si02) thin film as a low refractive index layer and a niobium oxide ($Nb_2O_5$) thin film as a high refractive index layer.

A method of forming the thin film constituting the antireflective layer 202 may be, but not particularly limited to, a wet coating method or a dry coating method. From a view point of being capable of forming a dense thin film having an even film thickness, the dry coating method such as vacuum deposition, CVD, sputtering, electron beam deposition are preferable. Sputtering among others is particularly preferable, because of its capability of forming a film having high mechanical strength. Productivity of the antireflective film can be increased by continuously forming films with conveying elongate film substrates in one direction (longitudinal direction thereof) by a roll-to-roll process.

In sputtering, a deposition material is sputtered from a target by bringing a high-energy sputtering gas (e.g., Ar) into collision with the target, and thus sputtered particles also have high energy. Therefore, in sputtering, a dense film is more likely to be formed, as compared with vacuum deposition or CVD Generally, a thin film formed by sputtering has a low water vapor permeability, e.g., the water vapor permeability of a silicon oxide film is equal to or less than 10 $g/m^2 \cdot 24$ h, in many cases.

A thin film having a water vapor permeability of equal to or less than 15 $g/m^2$ 24 h can be formed by adjusting conditions for sputtering film formation. For example, when a discharge voltage during sputtering film formation is relatively low, kinetic energy of sputtered particles is reduced, so that diffusion at the surface of a substrate is suppressed. Thus, the film is apt to grow in a columnar shape, so that it is likely to become porous. When the discharge voltage is relatively high, the film is apt to be formed in a planar shape, so that it is likely to become dense. On the other hand, when the discharge voltage is excessively increased, neutral particles such as recoil Ar damages the surface of the film to cause defects therein, so that the density of the film tends to be lowered.

In magnetron sputtering, a stronger magnetic field (higher magnetic flux density) tends to more suppress spreading of a plasma to provide a higher plasma density. Accordingly, the discharge voltage can be reduced, so that the film is more likely to grow in a columnar shape, as mentioned above, and the water vapor permeability tends to become larger. Further, the reduced kinetic energy of the sputtered particles due to the lowered discharge voltage can reduce the damage caused by recoil Ar particles or the like. Thus, the surface of the film is more likely to become smooth, thereby providing an antireflective film which is small in terms of arithmetic average roughness Ra, and excellent in terms of scratch resistance and fingerprint wiping-off property. The magnetic flux density of the surface of the target surface during sputtering film formation is preferably 20 mT or more, more preferably 35 mT or more, further preferably 45 mT or more, particularly preferably 55 mT or more.

When a pressure during the film forming is relatively high, an average free path of sputtered particles is reduced, and thus the directivity of sputtered particles is deteriorated, so that the sputtered particles is more likely to be diffused by Ar, and thus the film is more likely to become porous. On the other hand, when the film formation pressure is excessively high, a film formation rate is lowered. Further, when the film formation pressure is relatively high, plasma discharge tends to become unstable. In order to form an oxide thin film having high water vapor permeability and sufficient mechanical strength, the film formation pressure is preferably 0.4 Pa to 1.5 Pa.

In addition to the conditions for sputtering film formation, the surface profile or the like of the substrate serving as a base for film formation can also exert an influence on a film growth mode. For example, as mentioned above, when the surface of the transparent film substrate is subjected to plasma treatment, a sputtered film is more likely to grow in a columnar shape, due to irregularities formed at the surface, so that the water vapor permeability tends to become larger.

In a situation where the polarizing film laminate 12 provided with the antireflective layer 202 is exposed to a heating environment, water in the polarizing film 120 and the polarizing film-protective films 121, 122 will be vaporized and released to the outside. However, when the water vapor permeability of the antireflective layer 202 is relatively small, the water is less likely to be diffused to the outside. For example, when water is retained inside the polarizing film laminate 12, the transparent substrate 201 comprised of triacetyl cellulose is likely to be hydrolyzed, and protective performance for the polarizing film 120 tends to be deteriorated. Moreover, when the acetyl cellulose is hydrolyzed, a free acid is generated. In the presence of an acid, polyvinyl alcohol constituting the polarizing film 120 is likely to be formed into polyene, causing degradation of the polarizing film laminate 12. On the other hand, when the water vapor permeability of the antireflective layer 202 is relatively large, it is considered that water valorized and released from the polarizing film and the polarizing film-protective films 121, 122 is likely to be diffused from the surface of the antireflective layer 202 to the outside, so that retention of water is suppressed, and thereby degradation of the polarizing plate at high

temperatures is suppressed. Particularly, according to the features of this application, the problems of the polyene formation and others are suppressed by adjusting the iodide concentration of the polarizing film and the water content of the polarizing film laminate. Thus, it is possible to sufficiently suppress the retention of water without setting the water vapor permeability to an excessively high value,

The water vapor permeability of the antireflective layer 202 is preferably equal to or more than 15 $g/m^2 \cdot 24$ h, more preferably equal to or more than 20 $g/m^2 \cdot 24$ h, further preferably equal to or more than 30 $g/m^2 \cdot 24$ h. From a viewpoint of further improving durability at high temperatures, the water vapor permeability of the antireflective layer 202 may be equal to or greater than 100 $g/m^2 \cdot 24$ h or equal to or greater than 130 $g/m^2 \cdot 24$ h. If the water vapor permeability of the antireflective layer is excessively high, the durability at high temperatures tends to be deteriorated. Thus, the water vapor permeability of the antireflective layer 202 is preferably equal to or less than 1000 $g/m^2 \cdot 24$ h, more preferably equal to or less than 500 $g/m^2 \cdot 24$ h.

When measuring the water vapor permeability of the antireflective layer 202, the antireflective layer 202 is formed on the transparent substrate 201, and subjected to measurement of the water vapor permeability. This is because the antireflective layer 202 is a thin film, and thereby it is difficult to singly measure the water vapor permeability thereof. This is also because the water vapor permeability of the antireflective film 200 in which the antireflective layer 202 is provided on the transparent substrate can be deemed to be equal to the water vapor permeability of the antireflective layer 202, because the water vapor permeability of any of many resin films is sufficiently large, as compared with the water vapor permeability of an inorganic oxide layer. In this case, the water vapor permeability of the antireflective film 200 is preferably 15 to 1000 $g/m^2 \cdot 24$ h, more preferably 20 to 500 $g/m^2 \cdot 24$ h or more.

6-2. Reliability Test

Each sample having the layer configuration as shown in FIG. 6 was subjected to a reliability test. Each sample was prepared by laminating a glass plate (microscope slide manufactured by Matsunami Glass Ind. Ltd., part number: S2000423, spec.: water ground-edge 65 $\times$ 165 mm, thickness: 1.3 mm) to one surface of the polarizing film laminate 12 obtained in Inventive Example 11 through a pressure-sensitive adhesive 11, and laminating the antireflective film 200 to the other surface of the polarizing film laminate 12 through a pressure-sensitive adhesive 13.

A 40 $\mu$m-thick film comprised of triacetyl cellulose was used as the transparent substrate 201 of the antireflective film 200. An antireflective layer 202 composed of a Si02 single layer was formed on the transparent substrate 201 by sputtering. The water vapor permeability of the transparent substrate 201 was changed by adjusting the conditions for sputtering film formation, more specifically by adjusting the flow rate of sputtering gas such as Ar, the film formation pressure and a film formation temperature. As each of the pressure-sensitive adhesives 11, 13, CS98219US (manufactured by Nitto Denko Corporation) having a thickness of 250 $\mu$m was used.

6-3. Measurement of Water Vapor Permeability

The water vapor permeability of the antireflective layer 202 was measured by measuring the water vapor permeability of the antireflective film 200 in an atmosphere having a humidity of 90%RH, according to Annex B of JIS K7129: 2008.
The water vapor permeability of the transparent substrate 201 is sufficiently larger than that of the antireflective layer 202. Thus, the water vapor permeability of the entirety of the antireflective film 200 was deemed to be equal to the water vapor permeability of the antireflective layer 202.

Results of the evaluation are shown in the following Table 3.

[TABLE 3]

| | Film Thickness of Polarizing Film (μm) | Iodine Concent ration (wt%) | Water Content (g/m$^2$) | Result of Reliability | 95° C/500 H | 95° C/250 H | | Water Vapor Permeability (g/m2 . 24h) |
|---|---|---|---|---|---|---|---|---|
| | | | | | Amount of Change in Single Transmittance (%) | Amount of Change (%) in Crossed Transmittance at 410 nm | Amount of Change (%) in Crossed Transmittance at 700 nm | |
| Inventive Example 15 | 18.0 | 3.0 | 3.5 | OK | 0.18 | 0.001 | 0.023 | 23.7 |
| Inventive Example 16 | 18.0 | 3.0 | 3.5 | OK | 0.18 | 0.005 | 0.031 | 60.3 |
| Inventive Example 17 | 18.0 | 3.0 | 3.5 | OK | 0.08 | 0.001 | 0.017 | 116.9 |
| Inventive Example 18 | 18.0 | 3.0 | 3.5 | OK | 0.01 | 0.000 | 0.019 | 160.3 |
| Inventive Example 19 | 18.0 | 3.0 | 3.5 | OK | 0.08 | 0.001 | 0.009 | 189.1 |
| Comparative | 18.0 | 3.0 | 3.5 | Plyene | -1.73 | 0.008 | 0.080 | 6.1 |
| Example 16 | | | | Formation | | | | |

7. Addition of Retardation Film

7-1. Layer Configuration

From a viewpoint of ensuring safety of a manipulator of a vehicle, the polarizing film laminate used for the vehicle preferably has a wide viewing angle. An optical display panel having improved viewing-angle characteristics can be formed by adding two retardation films as disclosed in, e.g., JP 2015-111236A (two-sheet compensation), or by adding one retardation film as disclosed in, e.g., JP 2016-148724A and JP 2006-72309A (one-sheet compensation). One example of a layer configuration of an optical display panel obtained by adding a retardation layer to the polarizing film laminate 12 is shown in each of FIGS. 7 and 8 in the form of a schematic diagram. In the following description, a layer element corresponding to the already-mentioned layer element will be assigned with the same reference sign as that of the already-mentioned layer element.

7-2. Two-Sheet Compensation

The layer configuration as shown in FIG. 7 is a layer configuration used for, e.g., an IPS-type liquid crystal cell 10. The liquid crystal cell 10 comprises a liquid crystal layer containing liquid crystal molecules oriented in one direction in a plane thereof in an electric field non-applied state. A first polarizing film 120 is disposed on one of opposite sides of the liquid crystal cell 10, i.e., on the side of a cover plate 14 with respect to the liquid crystal cell 10, and a second polarizing film 170 is disposed on the other side of the liquid crystal cell 10, i.e., on the side of a light source 18 with respect to the liquid crystal cell 10. The first polarizing film 120 and the second polarizing film 170 are arranged such that respective absorption axes thereof become orthogonal to each other.

A protective layer (polarizing film-protective film) 121 is bonded to the first polarizing film 120, on the side opposite to a first retardation layer 212, wherein a first polarizing film laminate 12 is formed by the first polarizing film 120 and the protective layer 121. The first polarizing film laminate 12 may further comprise an additional protective layer (equivalent to the polarizing film-protective film 122 in FIG. 1) on one surface thereof located on the side of the first retardation layer 212, and may further comprise an antireflective layer 202, as shown in FIG. 6. Any of the polarizing film laminates in the aforementioned Inventive Examples 1 to 19 may be used as the first polarizing film laminate 12.

The second polarizing film 170 is bonded to one of opposite surfaces of the liquid crystal cell 10 through a pressure-sensitive layer 16. A protective layer (polarizing film-protective film) 171 is bonded to one of opposite surfaces of the second polarizing film 170 located on the side opposite to the crystal cell 10, wherein a second polarizing film laminate 17 is formed by the second polarizing film 170 and the protective layer 171. The second polarizing film 170 may further comprises an additional protective layer (polarizing film-protective film) on the other surface thereof located on the side of the liquid crystal cell 10. Any of the polarizing film laminates in the aforementioned Inventive Examples 1 to 14 may be used as the second polarizing film laminate 12.

Between the first polarizing film laminate 12 (in this example, the first polarizing film 120 of the first polarizing film laminate 12) and the liquid crystal cell 10, the first retardation layer 212 and the second retardation layer 213 are arranged, in this order from the side of the first polarizing film 120.

The first retardation layer 212 is bonded to the surface of the first polarizing film 120. The second retardation layer 213 is bonded to one surface of the first retardation layer 212 through an adhesive layer or pressure-sensitive adhesive layer 19, located on the side opposite to the first polarizing film 120. Further, the second retardation layer 213 is bonded to the other surface of the liquid crystal cell 10 through an adhesive layer or pressure-sensitive adhesive layer 11. Here, the first retardation layer 212 and the second retardation layer 213 are arranged such that respective slow axes thereof become parallel to each other.

Examples of a material usable for the first retardation layer 212 may include: a polycarbonate-based resin; a polyester-based resin such as polyethylene terephthalate or polyethylene naphthalate; a polyarylate-based resin; a polyimide-based resin; a cyclic polyolefin-based (polynorbornene-based) resin; a polyamide resin; and a polyolefin-based resin such as polyethylene or polypropylene. Examples of a preferred material to be used as that for the second retardation layer may include an acrylic resin, a styrene-based resin, a maleimide-based resin, and a fumarate-based resin.

The first retardation layer 212 and the second retardation layer 213 are preferably used in the form of the following combination.

1. The first retardation layer 212 is configured to satisfy a relationship of $nx1 > ny1 > nz1$, where: nx1 represents a refractive index in an in-plane slow axis (x-axis) direction; ny1 represents a refractive index in an in-plane fast axis direction; and nz1 represents a refractive index in a thickness (z) direction, and the second retardation layer 213 is configured to satisfy a relationship of $nz2 > nx2 > ny2$, where: nx2 represents a refractive index in the in-plane slow axis (x-axis) direction; ny2 represents a refractive index in the in-plane fast axis direction; and nz2 represents a

refractive index in the thickness (z) direction.

In other words, an in-plane retardation Re of the first retardation layer 212 is in the following range: 10 nm < Re < 200 nm, and a thickness-directional retardation Rth expressed as Rth = (nxl - nz1) × d1 (where d1 represents the thickness of the first retardation layer) is in the following range: 10 nm < Rth < 300 nm. Further, an in-plane retardation Re of the second retardation layer 213 is in the following range: 10 nm < Re < 200 nm, and a thickness-directional retardation Rth expressed as Rth = (nx2 - nz2) × d2 (where d2 represents the thickness of the second retardation layer) is in the following range: 10 nm < Rth < - 300 nm.

2. The first retardation layer 212 is configured to satisfy a relationship of nx1 > ny1 > nz1, where: nx1 represents a refractive index in the in-plane slow axis (x-axis) direction; ny1 represents a refractive index in the in-plane fast axis direction; and nz1 represents a refractive index in the thickness (z) direction, and the second retardation layer 213 is configured to satisfy a relationship of nz2 > nx2 = ny2, where: nx2 represents a refractive index in the in-plane slow axis (x-axis) direction; ny2 represents a refractive index in the in-plane fast axis direction; and nz2 represents a refractive index in the thickness (z) direction.

In other words, the in-plane retardation Re of the first retardation layer 212 is in the following range: 10 nm < Re < 200 nm, and the thickness-directional retardation Rth expressed as Rth = (nxl - nz1) × d1 (where d1 represents the thickness of the first retardation layer) is in the following range: 10 nm < Rth < 300 nm. Further, the in-plane retardation Re of the second retardation layer 213 is in the following range: 0 nm < Re < 10 nm, and the thickness-directional retardation Rth expressed as Rth = (nx2 - nz2) × d2 (where d2 represents the thickness of the second retardation layer) is in the following range: 10 nm < Rth < - 300 nm.

3. The first retardation layer 212 is configured to satisfy a relationship of nz1 > nx1 = ny1, where: nx1 represents a refractive index in the in-plane slow axis (x-axis) direction; ny1 represents a refractive index in the in-plane fast axis direction; and nz1 represents a refractive index in the thickness (z) direction, and the second retardation layer 213 is configured to satisfy a relationship of nx2 > ny2 = nz2, where: nx2 represents a refractive index in the in-plane slow axis (x-axis) direction; ny2 represents a refractive index in the in-plane fast axis direction; and nz2 represents a refractive index in the thickness (z) direction.

In other words, the in-plane retardation Re of the first retardation layer 212 is in the following range: 0 nm < Re < 10 nm, and the thickness-directional retardation Rth expressed as Rth = (nxl - nz1) × d1 (where d1 represents the thickness of the first retardation layer) is in the following range: 10 nm < Rth < 300 nm. Further, the in-plane retardation Re of the second retardation layer 213 is in the following range: 10 nm < Re < 200 nm, and Nz = (nxl - nz1) / (nxl - ny1) is in the following range: 1 < Nz <3.

7-3. One-Sheet Compensation

The layer configuration as shown in FIG. 8 is used for, e.g., an IPS-type liquid crystal cell 10, as with the layer configuration in FIG. 7. A substantial difference from the layer configuration in FIG. 8 is in that a retardation film 215 is provided on only one side of a liquid crystal cell 10, i.e., only on the side of a cover plate 14 with respect to the liquid crystal cell 10. The retardation film 215 is disposed between a first polarizing film 120 and the liquid crystal cell 10. Although not particularly illustrated, on the contrary, a retardation film may be provided only on the side of a light source 18 with respect to the liquid crystal cell 10, and between a second polarizing film 170 and the liquid crystal cell 10. As with the layer configuration in FIG. 7, any of the polarizing film laminates in the aforementioned Inventive Examples 1 to 19 may be used as a first polarizing film laminate 12, and any of the polarizing film laminates in the aforementioned Inventive Examples 1 to 14 may be used as a second polarizing film laminate 17.

Preferably, the retardation layer 215 is configured to satisfy a relationship of nx > nz > ny, where: nx represents a refractive index in an in-plane slow axis (x-axis) direction; ny represents a refractive index in an in-plane fast axis direction; and nz represents a refractive index in a thickness (z) direction. In other words, it is preferable that an in-plane retardation Re of the retardation layer 215 is in the following range: 100 nm < Re < 500 nm, and a thickness-directional retardation Rth expressed as Rth = (nxl - nz1) × d1 (where d1 represents the thickness of the retardation layer) is in the following range: 10 nm < Rth < 300 nm.

The retardation layer 215 may be a retardation layer formed by: applying a retardation layer-forming solution to a substrate such as a biaxially-stretched polypropylene film; drying the applied solution; and stretching the resulting laminate in a width direction and contracting the laminate in a MD direction, using a simultaneous and biaxial stretching machine, while conveying the laminate, as disclosed in, e.g., JP 2016-148724A. In this case, the thickness of the retardation layer 215 may be 1 μm to 30 μm, more preferably 5 μm to 20 μm. The retardation layer 215 may also be a retardation layer formed by: laminating a contractable film to each or one of opposite surfaces of a polymer film serving as a retardation film; and applying, to the resulting laminate, a tensile force in a stretching direction of the polymer film and a contractive force in a direction orthogonal to the stretching direction, as disclosed in, e.g., JP 2006-72309A. In this case, the thickness of the retardation layer 215 may be 30 μm to 200 μm, more preferably 40 μm to 150 μm.

LIST OF REFERENCE SIGNS

1: optical display panel
10: optical display cell
11: transparent adhesive
12: polarizing film laminate
13: transparent adhesive
14: transparent cover plate
120: polarizing film
121: polarizing film-protective film
122: polarizing film-protective film

## Claims

**1.** A polarizing film laminate used for an optical display panel configured to be mounted to a vehicle body of a powered vehicle, comprising a polarizing film comprised of a polyvinyl alcohol-based resin, and an optically transparent, polarizing film-protective film bonded to at least one of opposite surfaces of the polarizing film directly or through an additional optical film, wherein the polarizing film laminate contains an iodine concentration for the polarizing film and a water content for the polarizing film laminate which fall within a region surrounded, in an x-y orthogonal coordinate system in which the iodine concentration (wt.%) of the polarizing film is plotted on the x-axis, and the water content ($g/m^2$) of the polarizing film laminate is plotted on the y-axis, by:

a first line segment connecting a first coordinate point at which the iodine concentration is 7.0 wt% and the water content is 0.7 $g/m^2$, and a second coordinate point at which the iodine concentration is 2.2 wt% and the water content is 3.2 $g/m^2$;
a second line segment connecting the second coordinate point, and a third coordinate point at which the iodine concentration is 2.2 wt% and the water content is 4.0 $g/m^2$;
a third line segment connecting the third coordinate point, and a fourth coordinate point at which the iodine concentration is 3.0 wt% and the water content is 4.0 $g/m^2$;
a fourth line segment connecting the fourth coordinate point, and a fifth coordinate point at which the iodine concentration is 10.0 wt% and the water content is 0.7 $g/m^2$; and
a fifth line segment connecting the first coordinate point, and the fifth coordinate point.

**2.** The polarizing film laminate as recited in claim 1, wherein the polarizing film has a film thickness of 4 to 20 $\mu$m.

**3.** A polarizing film laminate used for an optical display panel configured to be mounted to a vehicle body of a powered vehicle, comprising a polarizing film comprised of a polyvinyl alcohol-based resin, and an optically transparent, polarizing film-protective film bonded to at least one of opposite surfaces of the polarizing film directly or through an additional optical film, wherein the polarizing film laminate contains an iodine concentration for the polarizing film and a water content for the polarizing film laminate which fall within a region surrounded, in an x-y orthogonal coordinate system in which the iodine concentration (wt.%) of the polarizing film is plotted on the x-axis, and the water content ($g/m^2$) of the polarizing film laminate is plotted on the y-axis, by:

a sixth line segment connecting a sixth coordinate point at which the iodine concentration is 4.5 wt% and the water content is 2.0 $g/m^2$, and a second coordinate point at which the iodine concentration is 2.2 wt% and the water content is 3.2 $g/m^2$;
a second line segment connecting the second coordinate point, and a third coordinate point at which the iodine concentration is 2.2 wt% and the water content is 4.0 $g/m^2$;
a third line segment connecting the third coordinate point, and a fourth coordinate point at which the iodine concentration is 3.0 wt% and the water content is 4.0 $g/m^2$;
a seventh line segment connecting the fourth coordinate point, and a seventh coordinate point at which the iodine concentration is 4.5 wt% and the water content is 3.3 $g/m^2$; and
an eighth line segment connecting the sixth coordinate point, and the seventh coordinate point.

**4.** The polarizing film laminate as recited in claim 3, wherein

the sixth coordinate point is a coordinate point at which the iodine concentration is 4.0 wt% and the water content is 2.3 g/$m^2$, and
the seventh coordinate point is a coordinate point at which the iodine concentration is 4.0 wt% and the water content is 3.5 g/$m^2$.

**5.** The polarizing film laminate as recited in claim 3 or 4, wherein the polarizing film has a film thickness of 11 to 20 μm.

**6.** A polarizing film laminate used for an optical display panel configured to be mounted to a vehicle body of a powered vehicle, comprising a polarizing film comprised of a polyvinyl alcohol-based resin, and an optically transparent, polarizing film-protective film bonded to at least one of opposite surfaces of the polarizing film directly or through an additional optical film, wherein the polarizing film laminate contains an iodine concentration for the polarizing film and a water content for the polarizing film laminate which fall within a region surrounded, in an x-y orthogonal coordinate system in which the iodine concentration (wt.%) of the polarizing film is plotted on the x-axis, and the water content (g/$m^2$) of the polarizing film laminate is plotted on the y-axis, by:

an eleventh line segment connecting a first coordinate point at which the iodine concentration is 7.0 wt% and the water content is 0.7 g/$m^2$, and an eighth coordinate point at which the iodine concentration is 3.3 wt% and the water content is 2.6 g/$m^2$;
a tenth line segment connecting the eighth coordinate point, and a ninth coordinate point at which the iodine concentration is 6.0 wt% and the water content is 2.6 g/$m^2$;
a twelfth segment connecting the ninth coordinate point, and a fifth coordinate point at which the iodine concentration is 10.0 wt% and the water content is 0.7 g/$m^2$; and
a fifth line segment connecting the first coordinate point, and the fifth coordinate point.

**7.** The polarizing film laminate as recited in claim 6, wherein

the eighth coordinate point is a sixth coordinate point at which the iodine concentration is 4.5 wt% and the water content is 2.0 g/$m^2$, and
the ninth coordinate point is a tenth coordinate point at which the iodine concentration is 7.2 wt% and the water content is 2.0 g/$m^2$, and

**8.** The polarizing film laminate as recited in claim 6 or 7, wherein the polarizing film has a film thickness of 4 to 11 μm.

**9.** The polarizing film laminate as recited in any one of claims 1 to 8, wherein the polarizing film contains zinc.

**10.** The polarizing film laminate as recited in any one of claims 1 to 9, wherein, with regard to a sample comprised of the polarizing film laminate recited in any one of claims 1 to 9 and two glass plates each laminated to a respective one of opposite surfaces of said polarizing film laminate through a pressure-sensitive adhesive layer, a single transmittance of the sample as measured after heating at 95°C for 500 hours is equal or greater than that of the sample before the heating.

**11.** The polarizing film laminate as recited in any one of claims 1 to 10, wherein, with regard to a sample comprised of the polarizing film laminate recited in any one of claims 1 to 10 and two glass plates each laminated to a respective one of opposite surfaces of said polarizing film laminate through a pressure-sensitive adhesive layer, an amount of change in cross transmittance of the sample at a wavelength of 410 nm due to heating at 95°C for 500 hours is less than 1%, and an amount of change in cross transmittance of the sample at a wavelength of 700 nm due to the heating is less than 5%.

**12.** The polarizing film laminate as recited in any one of claims 1 to 11, wherein, with regard to a sample comprised of the polarizing film laminate recited in any one of claims 1 to 11 and two glass plates each laminated to a respective one of opposite surfaces of said polarizing film laminate through a pressure-sensitive adhesive layer, an amount of change in cross transmittance of the sample at a wavelength of 410 nm due to heating at 95°C for 500 hours is 1% or more, and an amount of change in cross transmittance of the sample at a wavelength of 700 nm due to the heating is less than 5%.

**13.** The polarizing film laminate as recited in any one of claims 1 to 12, wherein an antireflective layer is provided on a viewing-side surface of the polarizing film through a substrate, and wherein an antireflective film comprised of the substrate and the antireflective layer has a water vapor permeability of equal to or more than 15 g/$m^2$· 24 h.

**14.** The optical display panel as recited in any of claims 1 to 13, which comprises:

a liquid crystal cell having a liquid crystal layer containing liquid crystal molecules oriented in one direction in a plane thereof in an electric field non-applied state;
a first polarizing film disposed on one of opposite sides of the liquid crystal cell;
a second polarizing film disposed on the other side of the liquid crystal cell, such that an absorption axis thereof becomes orthogonal to an absorption axis of the first polarizing film,
wherein a first retardation layer and a second retardation layer are arranged between the first polarizing film and the liquid crystal cell, in this order from a side of the first polarizing film, wherein the first retardation layer is configured to satisfy a relationship of $nx1 > ny1 > nz1$, where: nx1 represents a refractive index in an in-plane slow axis (x-axis) direction; ny1 represents a refractive index in an in-plane fast axis direction; and nz1 represents a refractive index in a thickness (z) direction, and the second retardation layer is configured to satisfy a relationship of $nz2 > nx2 \geqq ny2$, where: nx2 represents a refractive index in the in-plane slow axis (x-axis) direction; ny2 represents a refractive index in the in-plane fast axis direction; and nz2 represents a refractive index in the thickness (z) direction.

**15.** The optical display panel as recited in any of claims 1 to 13, which comprises:

a liquid crystal cell having a liquid crystal layer containing liquid crystal molecules oriented in one direction in a plane thereof in an electric field non-applied state;
a first polarizing film disposed on one of opposite sides of the liquid crystal cell;
a second polarizing film disposed on the other side of the liquid crystal cell, such that an absorption axis thereof becomes orthogonal to an absorption axis of the first polarizing film,
wherein a first retardation layer and a second retardation layer are arranged between the first polarizing film and the liquid crystal cell, in this order from a side of the first polarizing film, wherein the first retardation layer is configured to satisfy a relationship of $nz1 > nx1 = ny1$, where: nx1 represents a refractive index in an in-plane slow axis (x-axis) direction; ny1 represents a refractive index in an in-plane fast axis direction; and nz1 represents a refractive index in a thickness (z) direction, and the second retardation layer is configured to satisfy a relationship of $nx2 > ny2 = ny2$, where: nx2 represents a refractive index in the in-plane slow axis (x-axis) direction; ny2 represents a refractive index in the in-plane fast axis direction; and nz2 represents a refractive index in the thickness (z) direction.

**16.** The optical display panel as recited in any of claims 1 to 13, which comprises:

a liquid crystal cell having a liquid crystal layer containing liquid crystal molecules oriented in one direction in a plane thereof in an electric field non-applied state; and
a polarizing film disposed on one of opposite sides of the liquid crystal cell,
wherein a retardation layer is disposed between the polarizing film and the liquid crystal cell, wherein the retardation layer is configured to satisfy a relationship of $nx > nz > ny$, where: nx represents a refractive index in an in-plane slow axis (x-axis) direction; ny represents a refractive index in an in-plane fast axis direction; and nz represents a refractive index in a thickness (z) direction.

**17.** An optical display panel configured to be mounted to a vehicle body of a powered vehicle, comprising:

an optical display cell;
the polarizing film laminate as recited in any one of claims 1 to 13, bonded to one of opposite surfaces of the optical display cell directly or through an additional optical film; and
an optically transparent cover plate disposed along the polarizing film laminate, on a side opposite to the optical display cell,
wherein any adjacent two of the optical display cell, the polarizing film laminate and the transparent cover plate are adhesively attach to each other by a transparent adhesive layer filled therebetween in a gap-free manner.

**18.** The optical display panel as recited in claim 17, wherein the transparent cover plate has a function of a capacitive touch sensor.

**19.** The optical display panel as recited in claim 18, wherein an ITO layer serving as an element of the capacitive touch sensor is provided between the transparent cover plate and the polarizing film laminate.

FIG.1

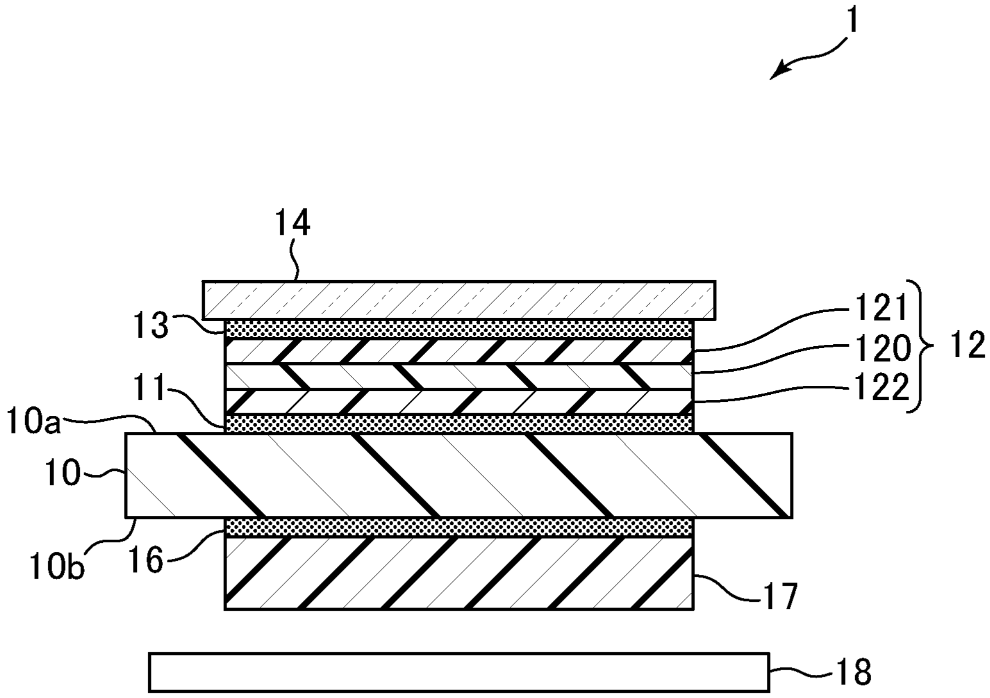

FIG.2

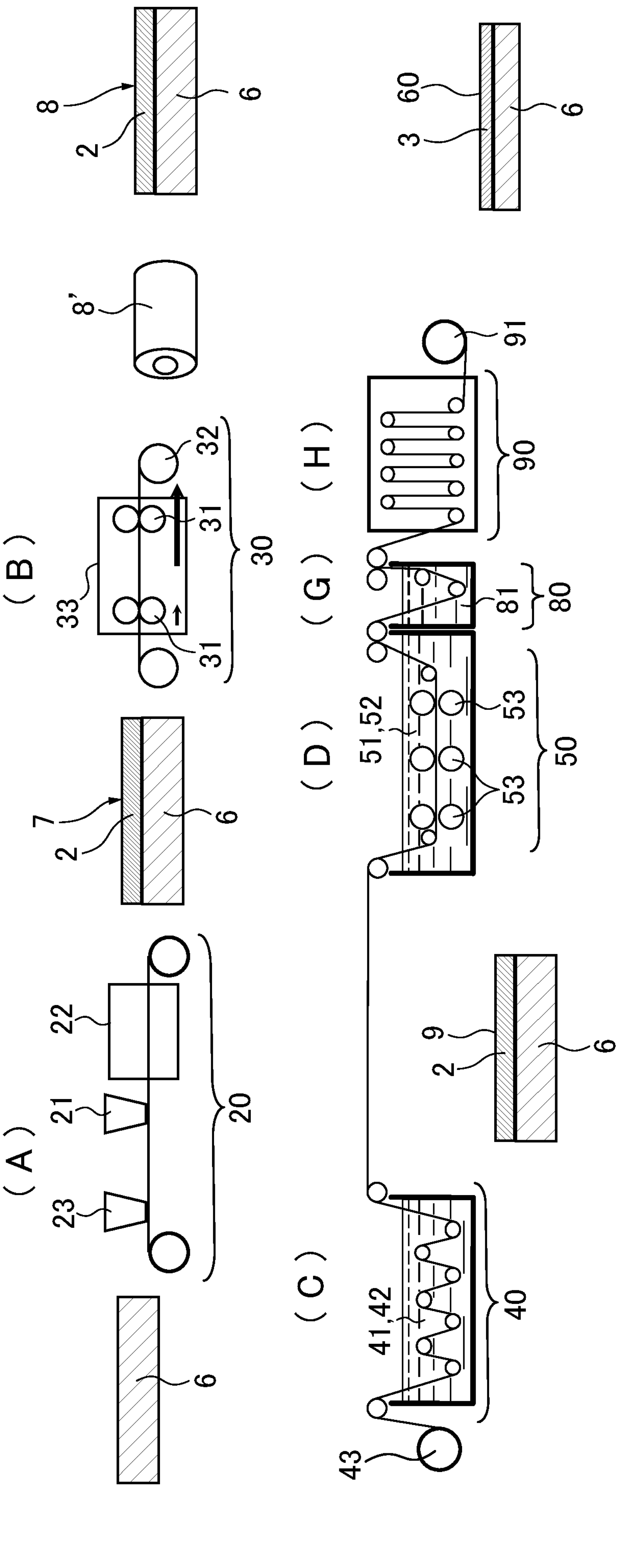
(A)
(B)
(C)
(D)
(G)
(H)
6
23
21
22
20
7
2
31
33
32
30
8'
8
41,42
40
43
9
51,52
53
50
81
80
90
91
3
60

# FIG.3

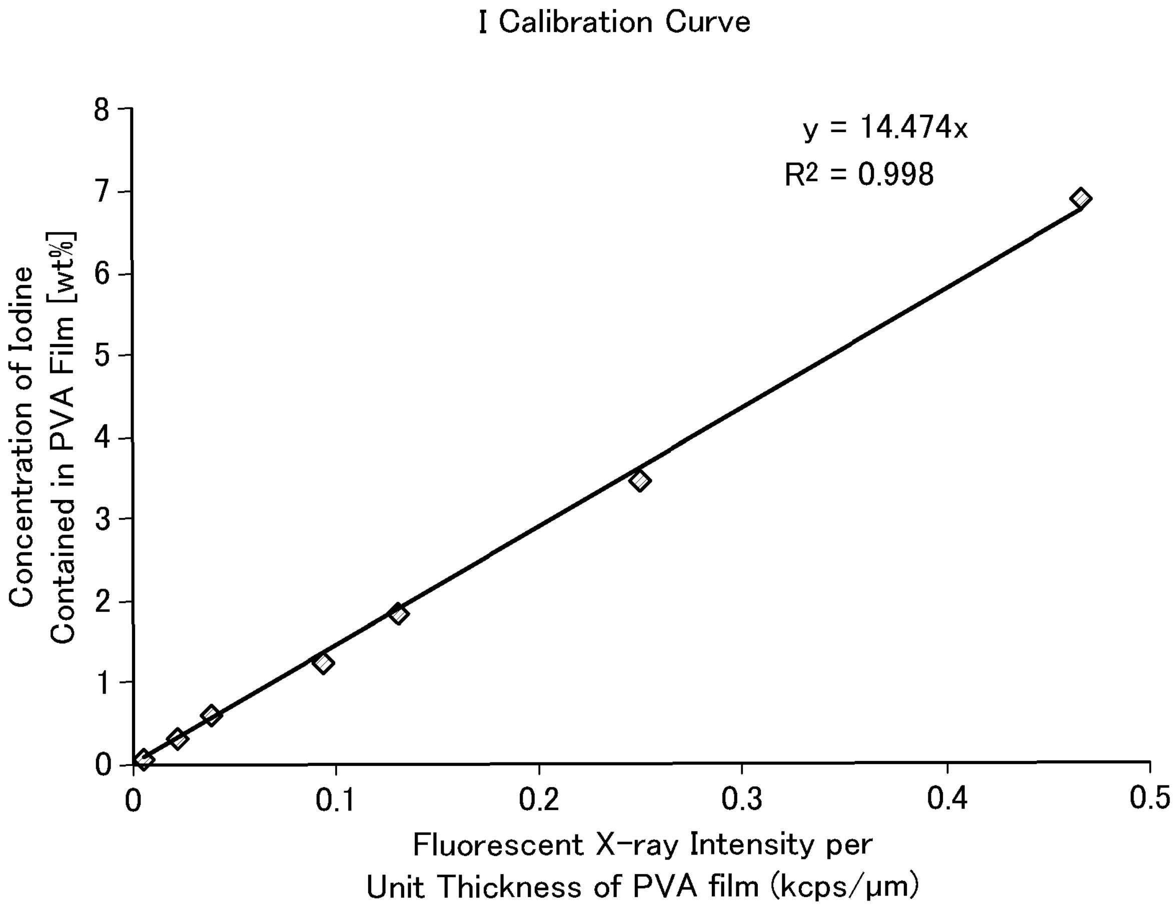
I Calibration Curve
y = 14.474x
R2 = 0.998
Concentration of Iodine Contained in PVA Film [wt%]
0
1
2
3
4
5
6
7
8
0
0.1
0.2
0.3
0.4
0.5
Fluorescent X-ray Intensity per Unit Thickness of PVA film (kcps/μm)

# FIG.4

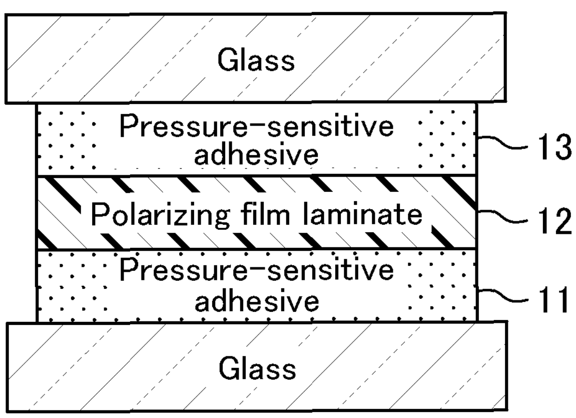
Glass
Pressure-sensitive adhesive
13
Polarizing film laminate
12
Pressure-sensitive adhesive
11
Glass

FIG.5

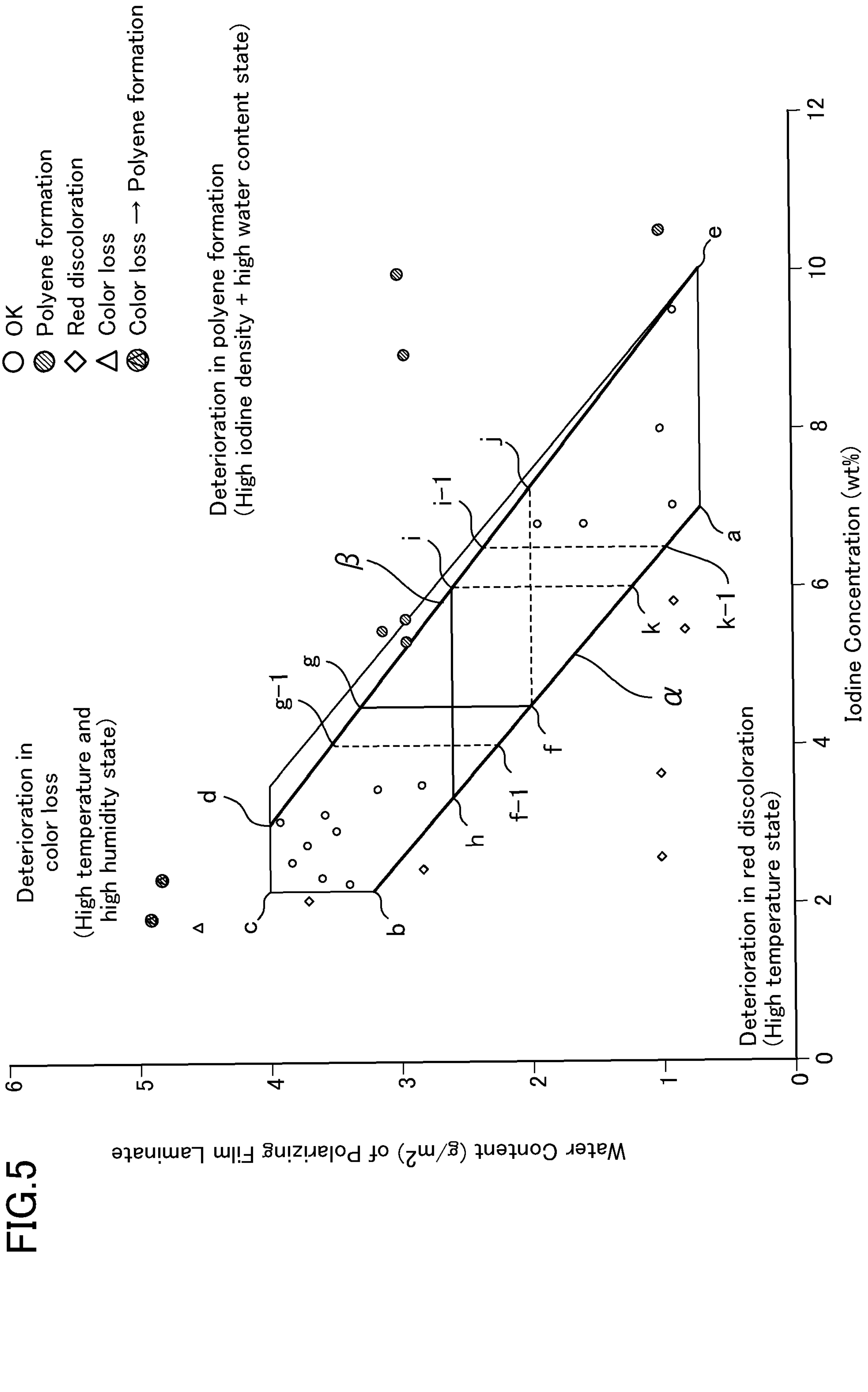
OK
Polyene formation
Red discoloration
Color loss
Color loss → Polyene formation
Deterioration in color loss
(High temperature and high humidity state)
Deterioration in polyene formation
(High iodine density + high water content state)
Deterioration in red discoloration
(High temperature state)
Water Content (g/m2) of Polarizing Film Laminate
Iodine Concentration (wt%)
0
1
2
3
4
5
6
0
2
4
6
8
10
12
a
b
c
d
e
f
f-1
g
g-1
h
i
i-1
j
k
k-1
α
β

FIG.6

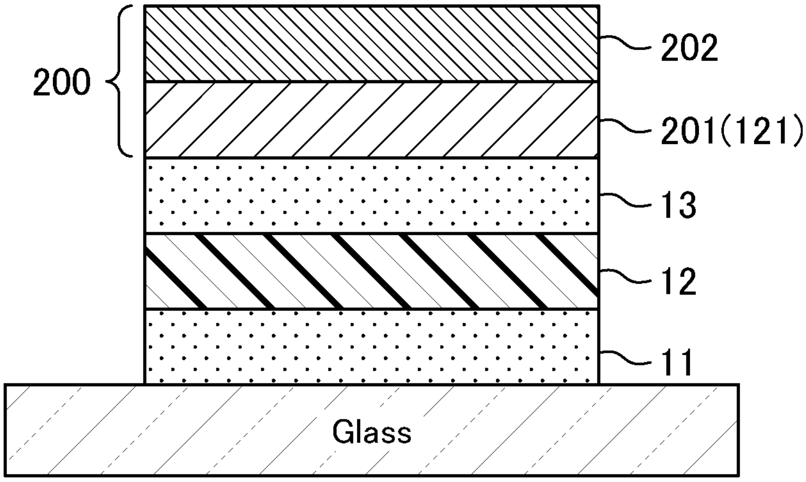
200
202
201(121)
13
12
11
Glass

FIG.7

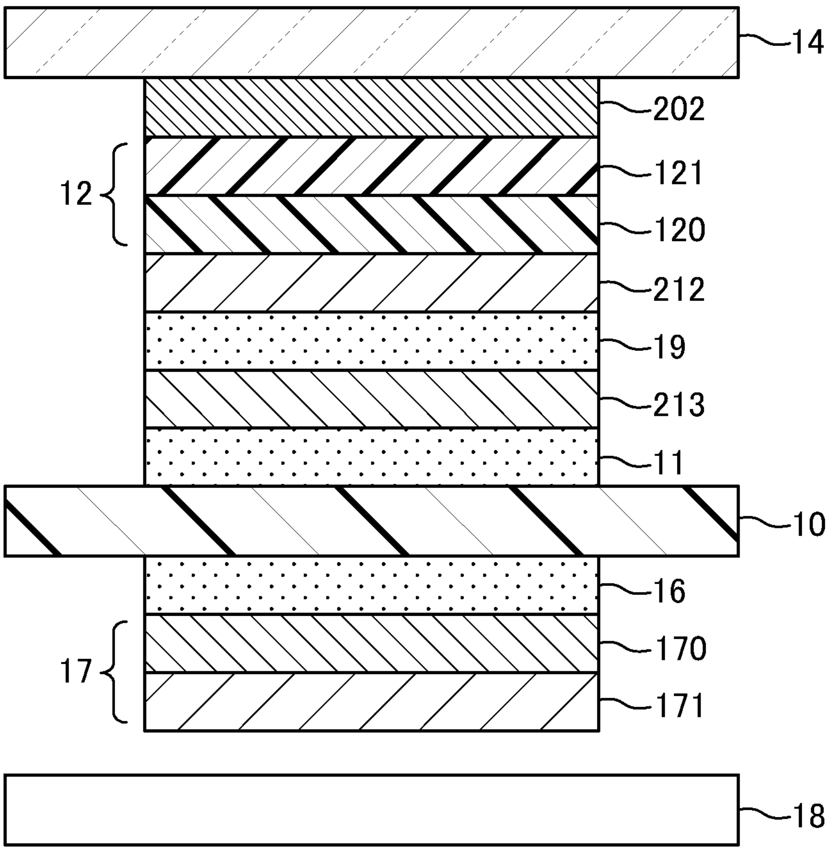
14
202
12
121
120
212
19
213
11
10
16
17
170
171
18

FIG.8

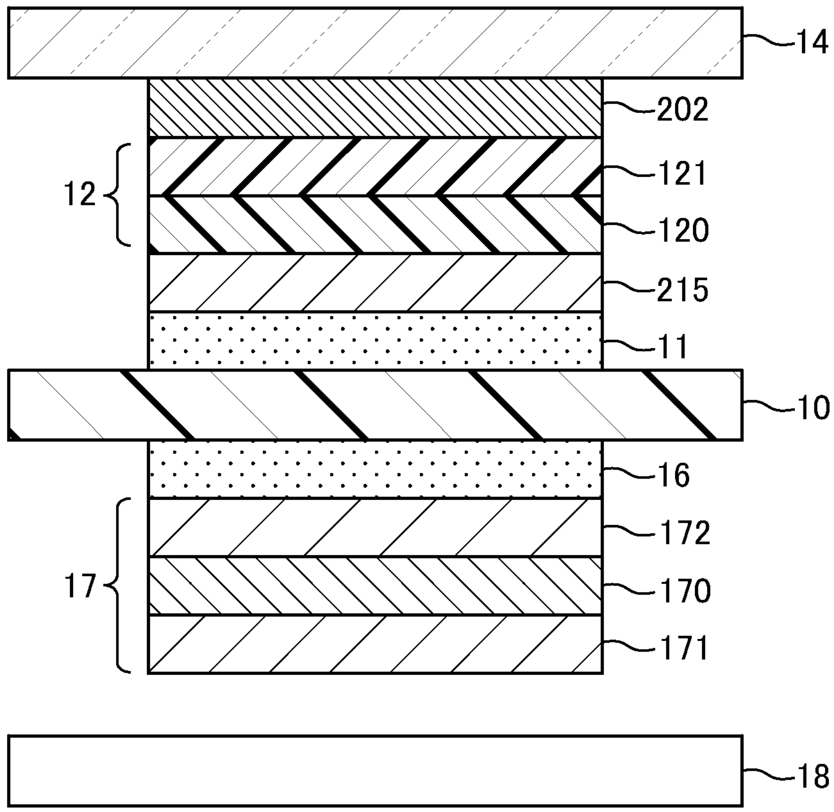

## INTERNATIONAL SEARCH REPORT

International application No.
PCT/JP2019/007955

A. CLASSIFICATION OF SUBJECT MATTER
Int.Cl. G02B5/30(2006.01)i, B32B7/023(2019.01)i, B60K35/00(2006.01)i, G02F1/1335(2006.01)i, G09F9/30(2006.1)i, H01L27/32(2006.01)i, H01L51/50(2006.01)i, H05B33/02(2006.01)i

According to International Patent Classification (IPC) or to both national classification and IPC

B. FIELDS SEARCHED
Minimum documentation searched (classification system followed by classification symbols)
Int.Cl. G02B5/30, B32B7/023, B60K35/00, G02F1/1335, G09F9/30, H01L27/32, H01L51/50, H05B33/02

Documentation searched other than minimum documentation to the extent that such documents are included in the fields searched

| | |
|---|---|
| Published examined utility model applications of Japan | 1922-1996 |
| Published unexamined utility model applications of Japan | 1971-2019 |
| Registered utility model specifications of Japan | 1996-2019 |
| Published registered utility model applications of Japan | 1994-2019 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| Y | JP 2003-29042 A (NITTO DENKO CORP.) 29 January 2003, paragraphs [0001], [0005], [0013]-[0014], [0021], [0025], [0054]-[0063] (Family: none) | 1-19 |
| Y | JP 2014-102353 A (NITTO DENKO CORP.) 05 June 2014, paragraphs [0002], [0013], [0097], [0102]-[0105], [0130]-[0137] (Family: none) | 1-19 |

☒ Further documents are listed in the continuation of Box C.  ☐ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 15 May 2019 (15.05.2019) | 28 May 2019 (28.05.2019) |

| Name and mailing address of the ISA/ | Authorized officer |
|---|---|
| Japan Patent Office<br>3-4-3, Kasumigaseki, Chiyoda-ku,<br>Tokyo 100-8915, Japan | Telephone No. |

Form PCT/ISA/210 (second sheet) (January 2015)

INTERNATIONAL SEARCH REPORT

International application No. PCT/JP2019/007955

C (Continuation). DOCUMENTS CONSIDERED TO BE RELEVANT

| Category* | Citation of document, with indication, where appropriate, of the relevant passages | Relevant to claim No. |
|---|---|---|
| Y | JP 2015-36729 A (NITTO DENKO CORP.) 23 February 2015, paragraphs [0001], [0027], [0054], [0072], [0087], fig. 7 & US 2015/0043070 A1, paragraphs [0001], [0024], [0087], [0108], [0124], fig. 7 & EP 2837489 A1 & CN 104375230 A & KR 10-2015-0020057 A & TW 201506470 A & KR 10-2016-0105375 A | 1-19 |
| Y | JP 2016-157081 A (NITTO DENKO CORP.) 01 September 2016, paragraphs [0001], [0004], [0006], [0019], [0025], [0085], [0096]-[0097], [0103] & US 2018/0045872 A1, paragraphs [0001], [0004], [0012], [0038], [0045], [0114], [0143]-[0144], [0150] & WO 2016/136509 A1 & TW 201636654 A & KR 10-2017-0122197 A & CN 107407757 A | 1-19 |
| Y<br>A | JP 2016-153886 A (SUMITOMO CHEMICAL COMPANY, LIMITED) 25 August 2016, paragraphs [0001], [0015], [0054], [0096], [0119]-[0128], [0133], [0136], [0138] & KR 10-2016-0099491 A & CN 105891930 A & TW 201632927 A | 1-2, 6-19<br>3-5 |
| Y | JP 2016-191900 A (NITTO DENKO CORP.) 10 November 2016, paragraphs [0017], [0019], [0024], [0043], [0076] & US 2016/0291373 A1, paragraphs [0019], [0022], [0028], [0049], [0081] & CN 106019684 A & KR 10-2016-0117176 A & TW 201640189 A | 14 |
| Y | JP 2007-206605 A (NITTO DENKO CORP.) 16 August 2007, paragraphs [0023], [0029] & US 2009/0002606 A1, paragraphs [0034]-[0038], [0099] & WO 2007/091467 A1 & KR 10-2008-0092415 A & CN 101379430 A & TW 200734738 A | 15 |
| Y | JP 2016-148724 A (NITTO DENKO CORP.) 18 August 2016, paragraphs [0019]-[0021], [0031] (Family: none) | 16 |
| Y | JP 2014-108541 A (FUJIFILM CORP.) 12 June 2014, paragraph [0178] & US 2015/0251393 A1, paragraph [0361] & WO 2014/084112 A1 & CN 104812569 A & KR 10-2015-0082338 A | 19 |
| A | WO 2016/104741 A1 (FUJIFILM CORP.) 30 June 2016, paragraphs [0058]-[0059] & US 2017/0254938 A1, paragraphs [0174]-[0178] | 1-19 |

Form PCT/ISA/210 (continuation of second sheet) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2003029042 A
- JP 2014102353 A
- JP 2002090546 A
- JP 6071459 B
- JP 4751481 B
- JP 2017227898 A
- JP 2015111236 A
- JP 2016148724 A
- JP 2006072309 A